(19) Europäisches Patentamt
European Patent Office
Office européen des brevets

(11) EP 2 254 147 A1

(12) # EUROPEAN PATENT APPLICATION
published in accordance with Art. 153(4) EPC

(43) Date of publication:
**24.11.2010 Bulletin 2010/47**

(21) Application number: **09719000.3**

(22) Date of filing: **10.03.2009**

(51) Int Cl.:
***H01L 21/52*** (2006.01) ***C09J 7/02*** (2006.01)
***C09J 11/02*** (2006.01) ***C09J 133/20*** (2006.01)
***H01L 21/301*** (2006.01) ***H01L 25/065*** (2006.01)
***H01L 25/07*** (2006.01) ***H01L 25/18*** (2006.01)

(86) International application number:
**PCT/JP2009/001059**

(87) International publication number:
**WO 2009/113296 (17.09.2009 Gazette 2009/38)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **14.03.2008 JP 2008065568**

(71) Applicant: **Sumitomo Bakelite Co., Ltd.**
**Shinagawa-ku**
**Tokyo 140-0002 (JP)**

(72) Inventor: **TERAI, Takeo**
**Tokyo 140-0002 (JP)**

(74) Representative: **Müller, Christian Stefan Gerd et al**
**Dr. Volker Vossius**
**Patent- und Rechtsanwaltskanzlei**
**Geibelstrasse 6**
**81679 München (DE)**

(54) **RESIN VARNISH FOR SEMICONDUCTOR ELEMENT BONDING FILM FORMATION, SEMICONDUCTOR ELEMENT BONDING FILM, AND SEMICONDUCTOR DEVICE**

(57) The object of the present invention can be achieved by an adhesive film for semiconductor element, including: a (meth) acrylic ester copolymer (A); and a silica (B), wherein the (meth) acrylic ester copolymer (A) has a hydroxyl group and a carboxylic group, or has an epoxy group, and has a weight-average molecular weight of 100,000 to 1,000,000, wherein the silica (B) has mean particle diameter of 1 to 100 nm, and wherein none of a thermosetting resin and a curing agent (C) is contained in non-volatile components, or total contents of the thermosetting resin and the curing agent (C) in the non-volatile components is equal to or lower than 5 wt %.

FIG. 15

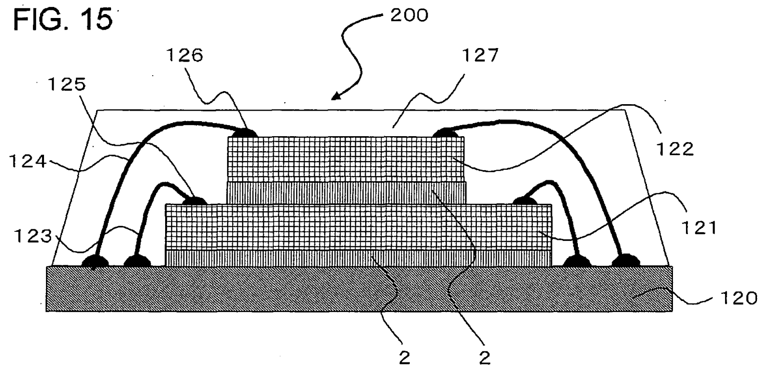


EP 2 254 147 A1

## Description

TECHNICAL FIELD

The present invention relates to a resin varnish used for an adhesive film for semiconductor element, an adhesive film for semiconductor element, and a semiconductor device.

BACHGRAOUND ART

In recent years, requirements for high-density assembly and high integration of semiconductor devices are increased in response to high-function of electronic equipments, and high capacity and high-density assembly for semiconductor devices are progressed.

In order to meet such requirements, an approach for, for example, depositing multiple-layered semiconductor elements over a semiconductor element to achieve miniaturization, reduced profile and increased capacity of semiconductor devices, is examined. In such semiconductor device, organic substrates such as a bismaleimide-triazine substrate, a polyimide substrate and the like are generally employed (Patent Document 1).

According to the above described Patent Document, an adhesive film for semiconductor element is mainly employed for providing an adhesion between a semiconductor element and an organic substrate or an adhesion between a semiconductor element and another semiconductor element in such semiconductor device, since it is difficult to carry out a suitable application of a paste-like adhesive agent of related art with a proper amount without overflowing the adhesive agent out of the semiconductor element.

The related arts for adhesive films for semiconductor elements also include technologies described in Patent Documents 2 to 4.

Patent Document 2 describes a use of an adhesive film for semiconductor element constituted of an epoxy resin and an acrylic rubber for providing an adhesion with a semiconductor element and a circuit board.

Patent Document 3 describes a use of an adhesive film for semiconductor element mainly constituted of a phenoxy resin for providing an adhesion with a semiconductor element and a circuit board.

Patent Document 4 describes that a control of flowability achieved by controlling minimum viscosity within a specific range at a temperature for adhesion of an adhesive film for semiconductor element.

[Patent Document 1] Japanese Patent Laid-Open No. 2006-73,982 (claims)
[Patent Document 2] Japanese Patent Laid-Open No. 2001-220,571 (claims)
[Patent Document 3] Japanese Patent Laid-Open No. 2002-138,270 (claims)
[Patent Document 4] Japanese Patent Laid-Open No. H11-12,545 (1999) (claims)

In consideration of providing an adhesion between a circuit board and a semiconductor element, a surface of a circuit board includes a metallic interconnect, and such metallic interconnect is covered with a solder resist, and since the surface includes a section having an metallic interconnect and a section without thereof, an irregularity is present in the surface of the circuit board. However, such irregularity may not be adequately filled with the adhesive film for semiconductor element described in the above-described Patent Documents when semiconductor elements are bonded to a circuit board, so that a spacing (void) is generated between the circuit board and the semiconductor elements, causing a problem of deteriorating a reliability of the semiconductor device.

The semiconductor elements are bonded to the circuit board via the adhesive film for the semiconductor element, and a wire bonding between the semiconductor element and the circuit board is provided, and then a heating and a pressurizing process carried out for a process for injecting an encapsulating resin, which is utilized for filling the irregularities of the circuit board surface by an adhesive film for semiconductor element. Therefore, the flowability of the adhesive film for semiconductor element in the injection of the encapsulating resin is important.
In addition, increased stacks of multiple semiconductor elements in recent years require increased time for an operation for providing wire bonding, and therefore the adhesive film for semiconductor element is subjected to a thermal history for longer time until the encapsulating resin is injected, as compared with the conventional process. Therefore, the reaction for curing the adhesive film for the semiconductor element proceeds before the injection of the encapsulating resin to deteriorate the flowability, causing a defect in a failure of filling the irregularities in the surface of the circuit board.

Further, miniaturization and reduced profile of the semiconductor device are progressed, which leads to progressed miniaturization and reduced profile of the semiconductor element. When smaller and thinner semiconductor elements are stacked to form a multiple-layer member with the adhesive films for semiconductor element, lower elastic modulus of the adhesive film for semiconductor element at the temperature for the wire bonding process may cause a move of the bonding pad during the wire bonding process, causing a problem of failing a precise wire bonding.

DISCLOSURE OF THE INVENTION

It is an object of the present invention to provide an adhesive film for a semiconductor element and a semiconductor device, with improved filling capability over the irregularity in the surface of the circuit board during the process for injecting the encapsulating resin in a semiconductor device composed of multiple layers of stacked semiconductor elements, even if longer thermal history is applied for an adhesion layer of the adhesive film for semiconductor element before the injection of the encapsulating resin due to longer time required for the wire bonding process.
It is another object of the present invention to provide an adhesive film for semiconductor element and a semiconductor device, with enhanced wire bonding capability in a semiconductor device composed of multiple layers of stacked smaller and thinner semiconductor elements.
Such objects are achieved by the present inventions as set forth in [1] to [24]:

[1]
A resin varnish used for an adhesive film for semiconductor element, including:

a (meth) acrylic ester copolymer (A); and
a silica (B),
wherein the (meth) acrylic ester copolymer (A) has a hydroxyl group and a carboxylic group, or has an epoxy group, and has a weight-average molecular weight of 100,000 to 1,000,000, wherein the silica (B) has mean particle diameter of 1 to 100 nm, and wherein none of a thermosetting resin and a curing agent (C) is contained in non-volatile components, or total contents of the thermosetting resin and the curing agent (C) in the non-volatile components is equal to or lower than 5 wt %.

[2]
The resin varnish used for the adhesive film for semiconductor element as set forth in [1], wherein the (meth) acrylic ester copolymer (A) is a random copolymer containing structural units represented in the following general formula (I), (II), (III), and (IV):

[formula 1]

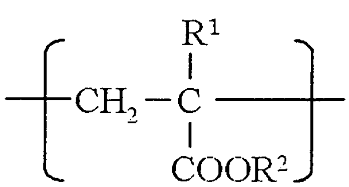 ( I ) 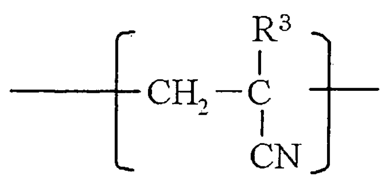 ( II )

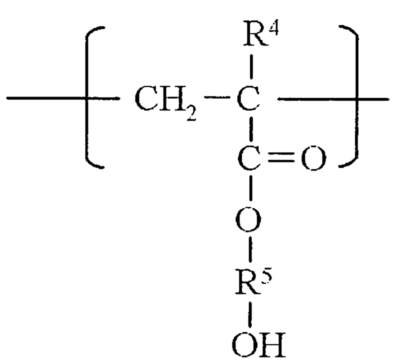 ( III ) 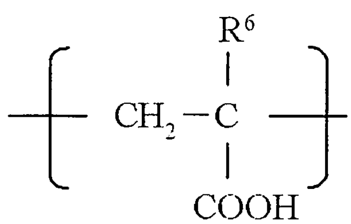 ( IV )

(where each of $R^1$, $R^3$, $R^4$ and $R^6$ represents a hydrogen atom or a methyl group; $R^2$ represents an alkyl group having 1 to 10 carbon atoms; and $R^5$ represents an alkylene group having 1 to 10 carbon atoms).
[3] The resin varnish used for the adhesive film for semiconductor element as set forth in [2], wherein molar ratio of

the structural unit (I) is 30 to 88 mol %, molar ratio of the structural unit (II) is 10 to 68 mol %, molar ratio of the structural unit (III) is 1 to 10 mol %, and molar ratio of the structural unit (IV) is 1 to 10 mol %.

[4] The resin varnish used for the adhesive film for semiconductor element as set forth in [1], wherein the (meth) acrylic ester copolymer (A) is a random copolymer containing structural units represented by the following general formula (V), (VI) and (VII);

[formula 2]

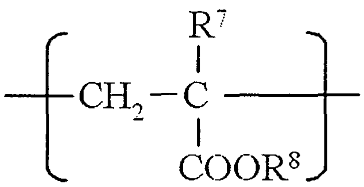
(V)

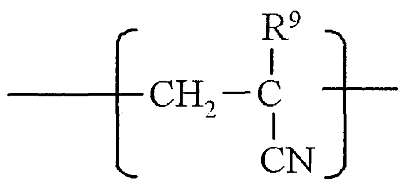
(VI)

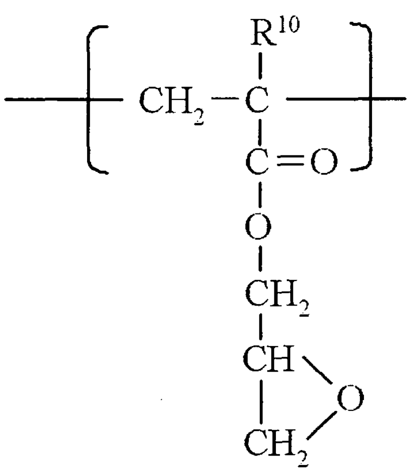
(VII)

(where each of $R^7$, $R^9$ and $R^{10}$ represents a hydrogen atom or a methyl group; and $R^8$ represents an alkyl group having 1 to 10 carbon atoms.

[5] The resin varnish used for the adhesive film for semiconductor element as set forth in [4], wherein molar ratio of the structural unit (V) is 30 to 88 mol %, molar ratio of the structural unit (VI) is 10 to 68 mol %, and molar ratio of the structural unit (VII) is 0.5 to 10 mol %.

[6] The resin varnish used for the adhesive film for semiconductor element as set forth in [3], wherein a content of the silica (B) is 20 to 70 mass %.

[7] The resin varnish used for the adhesive film for semiconductor element as set forth in [5], wherein a content of the silica (B) is 20 to 70 mass %.

[8] The resin varnish used for the adhesive film for semiconductor element as set forth in [3], wherein the particle diameter of the silica (B) is 10 to 30 nm.

[9] The resin varnish used for the adhesive film for semiconductor element as set forth in [5], wherein the particle diameter of the silica (B) is 10 to 30 nm.

[10] An adhesive film for semiconductor element containing a base material film and an adhesive layer, wherein the adhesive layer contains:

a (meth) acrylic ester copolymer (A); and
a silica (B),
wherein the (meth) acrylic ester copolymer (A) has a hydroxyl group and a carboxylic group, or has an epoxy group, and has a weight-average molecular weight of 100,000 to 1,000,000,
wherein the silica (B) has mean particle diameter of 1 to 100 nm, and
wherein none of a thermosetting resin and a curing agent (C) is contained in non-volatile components, or total contents of the thermosetting resin and the curing agent (C) in the non-volatile components is equal to or lower

than 5 wt %.

[11]
The adhesive film for semiconductor element as set forth in [10], wherein the (meth) acrylic ester copolymer (A) is a random copolymer containing structural units represented in the following general formula (I), (II), (III), and (IV):

[formula 3]

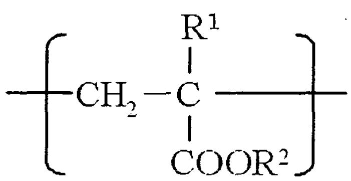
(I)

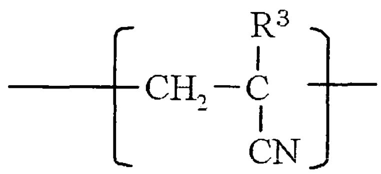
(II)

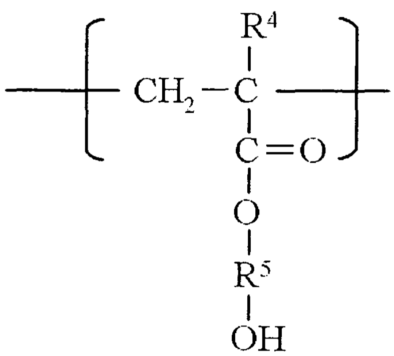
(III)

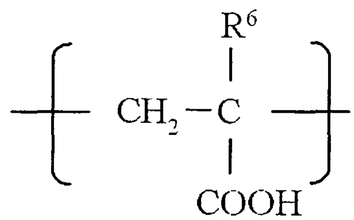
(IV)

(where each of $R^1$, $R^3$, $R^4$ and $R^6$ represents a hydrogen atom or a methyl group; $R^2$ represents an alkyl group having 1 to 10 carbon atoms; and $R^5$ represents an alkylene group having 1 to 10 carbon atoms).

[12]
The adhesive film for semiconductor element as set forth in [11], wherein molar ratio of the structural unit (I) is 30 to 88 mol %, molar ratio of the structural unit (II) is 10 to 68 mol %, molar ratio of the structural unit (III) is 1 to 10 mol %, and molar ratio of the structural unit (IV) is 1 to 10 mol %.

[13]
The adhesive film for semiconductor element as set forth in [10], wherein the (meth) acrylic ester copolymer (A) is a random copolymer containing structural units represented by the following general formula (V), (VI) and (VII);

[formula 4]

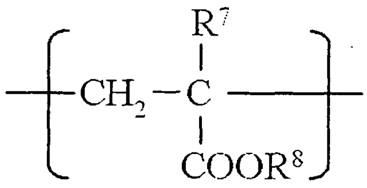 (V) 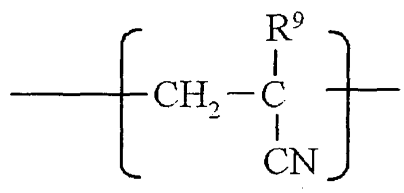 (VI)

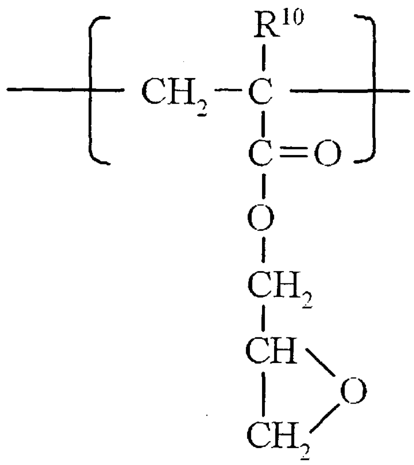 (VII)

(where each of $R^7$, $R^9$ and $R^{10}$ represents a hydrogen atom or a methyl group; and $R^8$ represents an alkyl group having 1 to 10 carbon atoms).

[14]

The adhesive film for semiconductor element as set forth in [13], wherein molar ratio of structural unit the (V) is 30 to 88 mol %, molar ratio of structural unit the (VI) is 10 to 68 mol %, and molar ratio of structural unit the (VII) is 0.5 to 10 mol %.

[15]

The adhesive film for semiconductor element as set forth in [12], wherein a content of the silica (B) is 20 to 70 mass % in the adhesive layer.

[16]

The adhesive film for semiconductor element as set forth in [14], wherein a content of the silica (B) is 20 to 70 mass % in the adhesive layer.

[17]

The adhesive film for semiconductor element as set forth in [12], wherein the particle diameter of the silica (B) is 10 to 30 nm.

[18]

The adhesive film for semiconductor element as set forth in [14], wherein the particle diameter of the silica (B) is 10 to 30 nm.

[19]

The adhesive film for semiconductor element as set forth in [12], wherein an elastic modulus at 175 degrees C is within a range of between not less than 30 MPa and not more than 140 MPa.

[20]

The adhesive film for semiconductor element as set forth in [14], wherein an elastic modulus at 175 degrees C is within a range of between not less than 30 MPa and not more than 140 MPa.

[21]

A composite adhesive film for semiconductor element, comprising: an adhesive film for semiconductor element as set forth in [12]; and a dicing film.

[22] A composite adhesive film for semiconductor element, comprising an adhesive film for semiconductor element as set forth in [14]; and a dicing film.

[23]
A semiconductor device, comprising:

a semiconductor element composed of stacked multiple layers
a substrate provided with the semiconductor element composed of stacked multiple layers; and
an adhesive layer provided between the semiconductor element and the semiconductor element or between the semiconductor element and the substrate,
wherein the adhesive layer is a cured material of the adhesive film for the semiconductor element as set forth in [12].

[24]
A semiconductor device, comprising:

a semiconductor elements composed of stacked multiple layers
a substrate provided with the semiconductor element composed of stacked multiple layers; and
an adhesive layer provided between the semiconductor element and the semiconductor element or between the semiconductor element and the substrate,
wherein the adhesive layer is a cured material of the adhesive film for the semiconductor element as set forth in [14].

According to the present invention, an adhesive film for a semiconductor element and a semiconductor device can be provided with improved filling capability for the irregularity in the surface of the circuit board during the process for injecting the encapsulating resin in a semiconductor device composed of multiple layers of stacked semiconductor elements, even if the thermal history applied for an adhesion layer of the adhesive film for semiconductor element before the injection of the encapsulating resin is increased due to longer time required for the wire bonding process. Further, an adhesive film for semiconductor element with enhanced wire bonding capability in a semiconductor device composed of multiple layers of stacked smaller and thinner semiconductor elements, and a semiconductor device, can be provided.

## BRIEF DESCRIPTION OF THE DRAWINGS

The above and other objects, advantages and features of the present invention will be more apparent from the following description of certain preferred embodiments taken in conjunction with the accompanying drawings:

Fig. 1 is a schematic diagram, which schematically illustrates an adhesive film for semiconductor element;
Fig. 2 is a schematic diagram, which schematically illustrates a first stacked-layer member;
Fig. 3 is a schematic diagram, which schematically illustrates an stacked-adhesive layer member;
Fig. 4 is a schematic diagram, which schematically illustrates a composite adhesive film A for semiconductor element;
Fig. 5 is a schematic diagram, which schematically illustrates a first stacked-adhesive layer member;
Fig. 6 is a schematic diagram, which schematically illustrates a second stacked-layer member;
Fig. 7 is a schematic diagram, which schematically illustrates a third stacked-layer member;
Fig. 8 is a schematic diagram, which schematically illustrates a second stacked-adhesive layer member;
Fig. 9 is a schematic diagram, which schematically illustrates a composite adhesive film B for semiconductor element;
Fig. 10 is a schematic diagram, which schematically illustrates a dicing sheet;
Fig. 11 is a flow chart, which presents a flow of a manufacture of a semiconductor device in an embodiment, in which an adhesive film for semiconductor element is employed;
Figs. 12-a to 12-f are schematic diagrams, which illustrate an operation for utilizing an adhesive film for semiconductor element in an embodiment;
Fig. 13 is a flow chart, which presents a flow of a manufacture of a semiconductor device in an embodiment, in which a composite adhesive film for semiconductor element having dicing function is employed;
Figs. 14-a to 14-e are schematic diagrams, which illustrate an operation for utilizing an adhesive film for semiconductor element in an embodiment; and
Fig. 15 is a schematic diagram, which schematically illustrates an example of a semiconductor device.

## BEST MODE FOR CARRYING OUT THE INVENTION

Resin varnishes used for adhesive films for semiconductor elements, adhesive films for semiconductor elements and semiconductor devices according to the present invention will be described as follows.

1. Resin Varnish Used for The Adhesive Film for semiconductor Element

A resin varnish used for an adhesive film for a semiconductor element according to the present invention includes a (meth) acrylic ester copolymer (A) having a hydroxyl group and a carboxylic group, or having an epoxy group, and having a weight-average molecular weight of 100,000 to 1,000,000 (hereinafter referred to as compound (A)), and silica (B) having a mean particle diameter of 1 to 100 nm (hereinafter referred to as compound (B)), or total contents of the thermosetting resin and the curing agent (C) in the non-volatile components of the varnish for adhesive film for semiconductor element formation is equal to or lower than 5 wt %. (hereinafter, the range presented by the expression of "a to b" includes the upper limit and the lower limit of the range). In particular, the total contents of the thermosetting resin and the curing agent (C) in the non-volatile components of the varnish for adhesive film for semiconductor element formation is equal to or lower than 5 wt %, so that improved filling capability for the irregularity in the surface of the circuit board during the process for injecting an encapsulating material, even if the thermal history applied for an adhesion layer of the adhesive film for semiconductor element is increased in a semiconductor device composed of multiple layers of stacked semiconductor elements, thereby providing enhanced reliability of the semiconductor device. The presence of the silica (B) having a mean particle diameter of 1 to 100 nm provides enhanced elastic modulus of the adhesive layer of the adhesive film for semiconductor element, so that improved wire bonding capability is achieved. In addition to above, a weight-average molecular weight is measured with a gel permeation chromatograph (GPC) in the present invention, and is presented by polystyrene-conversion value.

The compound (A) according to the present invention contains a (meth) acrylic ester copolymer having a hydroxyl group and a carboxylic group, or having an epoxy group, and having a weight-average molecular weight of 100,000 to 1,000,000. The type of the compound (A) is not particularly limited, provided that the compound has a hydroxyl group and a carboxylic group, or has an epoxy group so as to induce a polymerization of (meth) acrylic ester copolymer in a process for curing the adhesive layer of the adhesive film for semiconductor element, and has the weight-average molecular weight of 100,000 to 1,000,000 so as to provide a compatibility between mechanical characteristics after the cure and a flowability in the adhesion of the adhesive layer of the adhesive film for semiconductor element.

The (meth) acrylic ester copolymer having a hydroxyl group and a carboxylic group and having a weight-average molecular weight of 100,000 to 1,000,000, though it is not particularly limited to any specific copolymer, may be a random copolymer that contains structural units represented by the following general formula (I), (II), (III), and (IV), and may be preferably a random copolymer composed of structural units represented by the following general formula (I), (II), (III), and (IV). The presence of the structural unit represented by the general formula (I) allows providing reduced elastic modulus of the adhesive layer of the adhesive film for the semiconductor element, so that an adhesiveness over a circuit board and/or a semiconductor element can be improved. In addition, the presence of the structural unit represented by the general formula (II) causes interaction of an acrylonitrile group having higher polarity with the circuit board or the semiconductor element in the adhesion with the adhesive film for the semiconductor element, so that the adhesiveness with the circuit board or the semiconductor element can be improved. Further, the presence of the structural units represented by the general formula (III) and (IV) causes ester reaction of a hydroxyl group and a carboxylic group in a (meth) acrylic ester copolymer in the thermal cure of the adhesive layer for the adhesive film for semiconductor element to create cross-linkage within molecule, so that the mechanical strength after the cure can be ensured.

[formula 5]

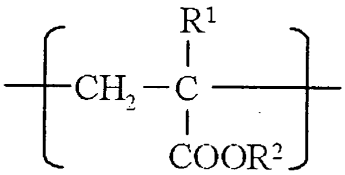 (I) 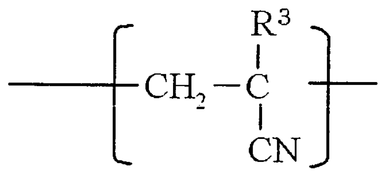 (II)

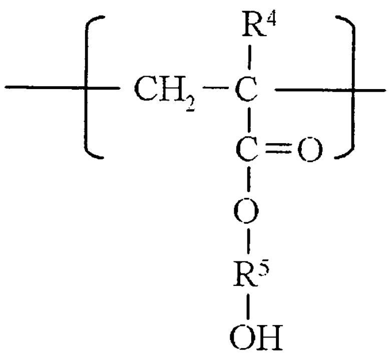 (III) 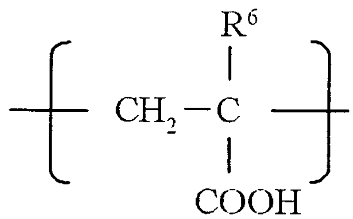 (IV)

(where $R^1$, $R^3$, $R^4$ and $R^6$ represent a hydrogen atom or a methyl group; and $R^2$ and $R^5$ represent an alkyl group having 1 to 10 carbon atoms.)

The (meth) acrylic ester copolymer having an epoxy group and having a weight-average molecular weight of 100,000 to 1,000,000, though is not particularly limited to any specific copolymer, may be a random copolymer that contains structural units represented by the following general formula (V), (VI) and (VII), and may be preferably a random copolymer composed of structural units represented by the following general formula (V), (VI) and (VII). The presence of the structural unit represented by the general formula (V) allows providing reduced elastic modulus of the adhesive layer of the adhesive film for the semiconductor element, so that an adhesiveness over a circuit board or a semiconductor element can be improved. In addition, the presence of the structural unit represented by the general formula (VI) causes interaction of an acrylonitrile group having higher polarity with the circuit board or the semiconductor element in the adhesion with the adhesive film for the semiconductor element, so that the adhesiveness with the circuit board or the semiconductor element can be improved. Further, the presence of the structural units represented by the general formula (VII) causes polymerization in an epoxy group of (meth) acrylic ester copolymer in the thermal cure of the adhesive layer for the adhesive film for semiconductor element to create cross-linkage within molecule, so that the mechanical strength after the cure can be ensured.

[formula 6]

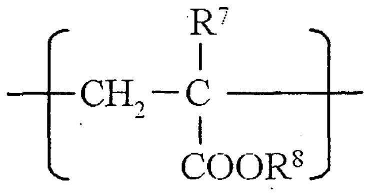 (V) 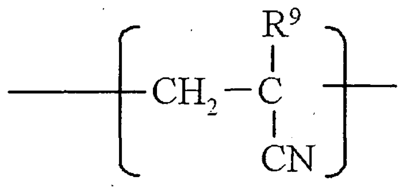 (VI)

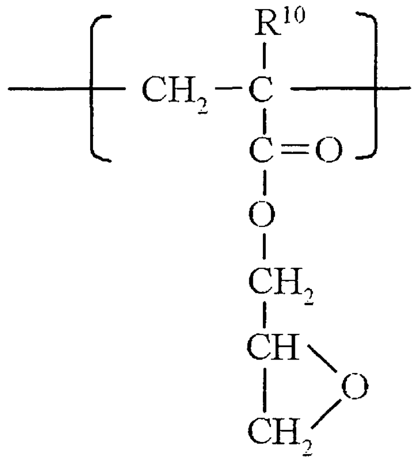 (VII)

(where $R^7$, $R^9$ and $R^{10}$ represent a hydrogen atom or a methyl group; and $R^8$ represents an alkyl group having 1 to 10 carbon atoms.)

The compound (A) according to the present invention typically includes a (meth) acrylic ester copolymer having a hydroxyl group and a carboxylic group, obtained by suspension addition polymerization with (meth) acrylic ester, (meth) acrylonitrile, a compound having a (meth) acryloyl group and hydroxyl group, and a compound having a (meth) acryloyl group and a carboxylic group, in the presence of radical initiator, a (meth) acrylic ester copolymer having an epoxy group obtained by suspension addition polymerization with (meth) acrylic ester, (meth) acrylonitrile, and a compound having a (meth) acryloyl group and an epoxy group in the presence of radical initiator.

The weight-average molecular weight of the above-described compound (A) is 100,000 to 1,000,000, and preferably 200,000 to 900,000. The weight-average molecular weight of the compound (A) within the above-described range provides a compatibility of the cohesion of the compound (A) and the flowability in the time of heating, so that a compatibility of the mechanical characteristics of the cured product of the adhesive layer of the adhesive film for semiconductor element and the flowability thereof in the time of the adhesion are achieved. In addition to above, the weight-average molecular weight may be measured with a gel permeation chromatography (GPC).

The (meth) acrylic ester copolymer having a hydroxyl group and a carboxylic group, though is not particularly limited to any specific copolymer, may be obtained by addition polymerization of (meth) acrylic ester, (meth) acrylonitrile, a compound having a (meth) acryloyl group and a hydroxyl group, and a compound having a (meth) acryloyl group and a carboxylic group in the presence of a radical initiator such as an organic peroxide, an azo compound and the like.

In addition, the (meth) acrylic ester copolymer having an epoxy group, though is not particularly limited to any specific copolymer, may be obtained by addition polymerization of (meth) acrylic ester, (meth) acrylonitrile, and a compound having a (meth) acryloyl group and an epoxy group in the presence of a radical initiator such as an organic peroxide, an azo compound and the like.

The above-described (meth) acrylic ester is not.particularly limited to any specific acrylic ester, provided that the polymerized product thereof has a structure of formula (I) or (V), and includes (meth) methyl acrylate, (meth) ethyl acrylate, (meth) n-propyl acrylate group, (meth) isopropyl acrylate, (meth) n-butyl acrylate group, (meth) isobutyl acrylate, and the like, and among these, (meth) ethyl acrylate and (meth) n- butyl acrylate group are preferable, in view of better flexibility and better adhesiveness of the cured product of the adhesive layer of the adhesive film for the semiconductor element.

The above-described compound having a (meth) acryloyl group and a hydroxyl group is not particularly limited to any specific compound, provided that the polymerized product thereof has a structure of formula (III), and includes

2-hydroxyethyl (meth) acrylate, 2-hydroxypropyl (meth) acrylate, 2-hydroxybutyl (meth) acrylate, caprolactone (meth) acrylate and the like, and among these, 2-hydroxyethyl (meth) acrylate is preferable because of better thermal resistance of the cured product of the adhesive layer of the adhesive film for the semiconductor element.

The above-described compound having (meth) acryloyl group and carboxylic group is not particularly limited to any specific compound, and includes (meth) acrylic acid, 2-(meth) acryloyloxy ethyl succinic acid, 2-methacryloyloxy ethyl hexahydrophthalic acid and the like, and among these, (meth) acrylic acid is preferable because of better thermal resistance of the cured product of the adhesive layer of the adhesive film for the semiconductor element.

In addition to above, in the present invention, the (meth) acrylic ester copolymer having a hydroxyl group and a carboxylic group is a random copolymer containing structural units represented in the following general formula (I) (II) (III), and (IV), and the molar ratio of the structural unit (I) is 30 to 88 mol %, molar ratio of the structural unit (II) is 10 to 68 mol %, molar ratio of the structural unit (III) is 1 to 10 mol % preferably, and molar ratio of the structural unit (IV) is 1 to 10 mol %, and it is more preferable, in view of better adhesiveness of the adhesive layer of the adhesive film for the semiconductor element and better thermal resistance of the cured product, that the molar ratio of the structural unit (I) is 35 to 70 mol %, molar ratio of the structural unit (II) is 20 to 60 mol %, molar ratio of the structural unit (III) is 2 to 8 mol %, and molar ratio of the structural unit (IV) is 2 to 8 mol %. The above-described (meth) acrylic ester copolymer having a hydroxyl group and a carboxylic group and having a weight-average molecular weight of 100,000 to 1,000,000 is presented for illustration only, and is not in particular limited thereto.

[formula 7]

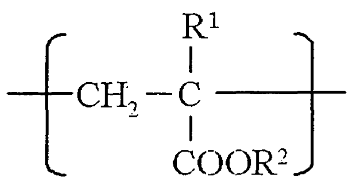 (I)

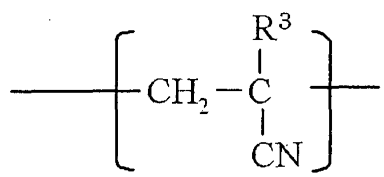 (II)

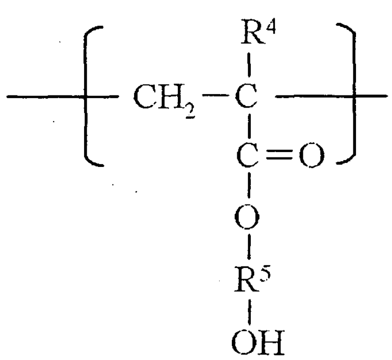 (III)

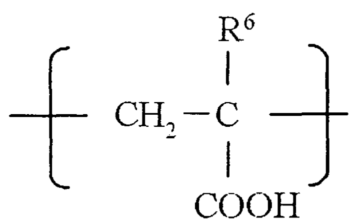 (IV)

(where $R^1$, $R^3$, $R^4$ and $R^6$ represent a hydrogen atom or a methyl group; and $R^2$ and $R^5$ represents an alkyl group having 1 to 10 carbon atoms.)

In addition, the (meth) acrylic ester copolymer having an epoxy group is a random copolymer containing structural units represented by the following general formula (V), (VI) and (VII), and and the molar ratio of the structural unit (V) is 30 to 88 mol %, molar ratio of the structural unit (VI) is 10 to 68 mol %, and molar ratio of the structural unit (VII) is 0.5 to 10 mol % preferably, and it is more preferable, in view of better adhesiveness of the adhesive layer of the adhesive film for the semiconductor element and better thermal resistance of the cured product, that the molar ratio of the structural unit (V) is 35 to 80 mol %, molar ratio of the structural unit (VI) is 15 to 60 mol %, and molar ratio of the structural unit (VII) is 1 to 8 mol %. The above-described (meth) acrylic ester copolymer having an epoxy group and having a weight-average molecular weight of 100,000 to 1,000,000 is presented for illustration only, and is not in particular limited thereto.

[formula 8]

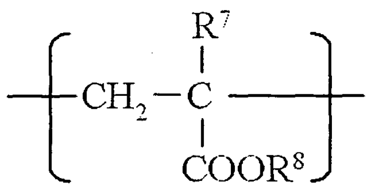 (V)

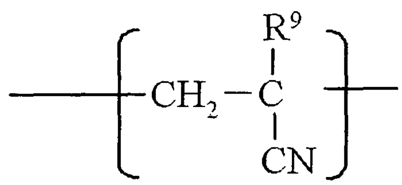 (VI)

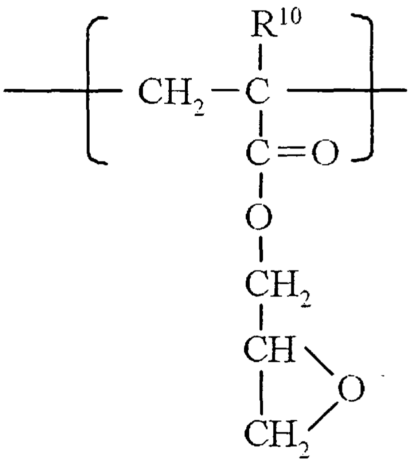 (VII)

(where each of $R^7$, $R^9$ and $R^{10}$ represents a hydrogen atom or a methyl group; and $R^8$ represents an alkyl group having 1 to 10 carbon atoms.)

The content of the compound (A) according to the present invention is preferably 20 to 80 mass % of the non-volatile components of the varnish for the adhesive film for the semiconductor element, and more preferably 30 to 70 mass %. The content of the compound (A) can be calculated by the following formula:

the content of the compound (A) (mass %) = [compound (A) (parts by mass)] / [compound (A) (parts by mass) + compound (B) (parts by mass) + thermosetting resin and curing agent (C) + other additives (parts by mass)] x 100

The compound (B) according to the present invention is silica having mean particle diameter of 1 to 100 nm. If the mean particle diameter of the above-described silica is larger than 100 nm, it is necessary to increase the adding quantity of the above-described silica to 70 mass % for enhancing the elastic modulus at higher temperature, and in such case, a problem of deteriorated adhesiveness or the like may be caused. Typical silica includes precipitated silica, fumed silica, colloidal silica and the like, and among these, colloidal silica is preferable. Since the level of the contamination with metal in the colloidal silica is lower than the precipitated silica and the fumed silica, the use of the colloidal silica allows reducing ionic impurity in the adhesive film for the semiconductor element. In addition, since the colloidal silica is formed of a silica dispersed in a solvent in a condition of substantially monodispersion, the blending into the resin varnish used for the adhesive film for the semiconductor element allows reducing the agglomeration of the silica.

The mean particle diameter of the above-described silica is preferably 5 to 80 nm, and more preferably 10 to 30 nm. The mean particle diameter within the above-described range allows providing the adhesive layer of the adhesive film for the semiconductor element with the well balanced adhesiveness and the elastic modulus at higher temperature.

The method for measuring the mean particle diameter of the above-described silica is as follows. Ultrasonic wave process is conducted in the water for one minute with a laser diffraction analyzer for particle size distribution SALD-7000 (commercially available from SHIMADZU) to disperse the silica therein to achieve the measurement. The value of D50 (number accumulation) is employed as the mean particle diameter.

The content of the compound (B) according to the present invention is preferably 20 to 80 mass % in the non-volatile component of the varnish used for the adhesive film for the semiconductor element, and more preferably 30 to 70 mass %. The content within the above-described range allows providing the adhesive layer of the adhesive film for the semiconductor element with the well balanced adhesiveness and the elastic modulus at higher temperature. The content of the compound (B) can be calculated by the following formula:

the content of the compound (B) (mass %) = [compound (B) (parts by mass)] / [compound (A) (parts by mass) + compound (B) (parts by mass) + thermosetting resin and curing agent (C) + other additives (parts by mass)] x 100

The total contents of the thermosetting resin and the curing agent (C) in the non-volatile component of the varnish for the formation of the adhesive film for forming the semiconductor element according to the present invention is equal to or lower than 5 mass %, and more preferably equal to or lower than 3 mass %. The total contents of the thermosetting resin and the curing agent (C) within the above-described range allows providing the adhesive layer of the adhesive film for the semiconductor element with improved filling capability for the irregularity in the surface of the circuit board during the process for injecting the encapsulating resin, even if the thermal history applied for an adhesion layer of the adhesive film for semiconductor element before the injection of the encapsulating resin is increased due to longer time required for the wire bonding process. Here, the total contents of the thermosetting resin and the curing agent (C) indicate for both of the thermosetting resin and the curing agent except the compound (A). The non-volatile component in the varnish used for the adhesive film for the semiconductor element indicates the sum of the total content of the compound (A), the compound (B), and the thermosetting resin with the curing agent (C) and the other additives added as required, and the total content of the thermosetting resin and the curing agent (C) can be calculated by the following formula:

The total content of the thermosetting resin and the curing agent (C) (mass %) = [thermosetting resin and curing agent (C) (parts by mass)] / [compound (A) (parts by mass) + compound (B) (parts by mass) + thermosetting resin and curing agent (C) + other additives (parts by mass)] x 100.

The above-described thermosetting resin is not particularly limited, and typically includes: novolac phenolic resins such as phenolic novolac resin, creosol novolac resin, bisphenol A novolac resin and the like; phenolic resins such as resol phenolic resins containing unmodified resol phenolic resin, oil-modified resol phenolic resin modified with tung oil and the like; bisphenolic epoxy resins such as bisphenol A epoxy resin, bisphenol F epoxy resin and the like; novolac epoxy resins such as phenolic novolac epoxy resin, creosol novolac epoxy resin and the like; epoxy resins such as biphenyl epoxy resin, hydroquinone epoxy resin, stilbene epoxy resin, triphenolic methane epoxy resin, triazine nucleus-containing epoxy resin, dicyclopenta diene-modified phenolic epoxy resin, naphthol epoxy resin, phenolic aralkyl epoxy resin, naphthol aralkyl epoxy resin and the like; resins having triazine ring such as urea resin, melamine resin

and the like; polyurethane resins; silicone resins; resins having benzoxazine ring; cyanate ester resins; acrylates such as urethane acrylate resin and the like; unsaturated polyester resins; diallyphthalate resins; maleimide resins and the like, and among these, an epoxy resin selected from novolac epoxy resins, bisphenolic epoxy resins, biphenyl epoxy resins and naphthol epoxy resins is preferably employed, in view of enhancing the elastic modulus of the cured product of the adhesive film for the semiconductor element and improving the adhesiveness of the adhesive interface. Here, a compound included in the compound (A) in the present invention is determined as being excluded from the thermosetting resin and the curing agent (C).

When the epoxy resin is employed for the above-described thermosetting resin, it is preferable to contain a curing agent, though it is not limited thereto. The above-described curing agent typically includes, for example: amine curing agents such as: aliphatic polyamines such as diethylenetriamine (DETA), triethylenetetramine (TETA), metaxylylenediamine (MXDA) Of and the like; aromatic polyamines such as diaminodiphenyl methane (DDM), m-phenylenediamine (MPDA), diaminodiphenylsulphone (DDS) and the like; and polyamine compounds such as dicyandiamide (DICY), organic acid dihydrazide, and the like; acid anhydride curing agents such as: alicyclic acid anhydrides (liquid acid anhydrides) such as hexahydrophthalic anhydride (HHPA), methyl tetrahydrophthalic anhydride (MTHPA) and the like; and aromatic acid anhydrides such as anhydrous trimellitic acid (TMA), pyromellitic dianhydride (PMDA), benzophenone tetracarboxylic acid dianhydride (BTDA) and the like; and phenolic curing agents such as phenolic resin and the like. Among these, the phenolic curing agents are preferable, in view of providing increased glass-transition temperature of the cured product of the adhesive film for the semiconductor element, and more specifically the phenolic curing agents typically include compounds of: various types of isomers of: bisphenols such as bis(4-hydroxy-3,5-dimethyl phenyl) methane (synonym: tetramethyl bisphenol F), 4,4'-sulphonyldiphenol, 4,4'-isopropylidene diphenol (synonym: bisphenol A) bis(4-hydroxyphenyl) methane, bis(2-hydroxyphenyl) methane, (2-hydroxyphenyl)(4-hydroxyphenyl) methane, and a mixture of three of these bisphenols, namely a mixture of bis(4-hydroxyphenyl) methane, bis(2-hydroxyphenyl) methane and (2-hydroxyphenyl)(4-hydroxyphenyl) methane (for example, commercially available from Honshu Chemical Industry Co., Ltd. under the trade name of "Bisphenol F-D") and the like; dihydroxybenzenes such as 1,2-benzendiol, 1,3- benzendiol, 1,4- benzendiol and the like; trihydroxybenzenes such as 1,2,4- benzenetriol and the like; and dihydroxynaphthalene such as 1,6- dihydroxynaphthalene and the like; and various types of isomers of biphenols such as 2,2'- bi phenol, 4,4'- bi phenol and the like.

The adding quantity of the above-described curing agent is not particularly limited to any specific quantity, and may be determined by calculating an equivalent ratio of the epoxy equivalent and the equivalent of the curing agent, and the equivalent ratio of the epoxy equivalent of the above-described epoxy resin and the equivalent of the curing agent is preferably 0.5 to 1.5, and particularly preferably 0.7 to 1.3. The equivalent ratio within the above-described range provides a compatibility of the storage stability of the above-described adhesive layer and the thermal resistance of the cured product.

When the epoxy resin is employed for the above-described thermosetting resin, it is preferable to contain curing catalyst, which provides further improvement in the curability of adhesive film for the semiconductor element, though it is not limited thereto. The above-described curing catalyst typically includes, for example: imidazoles; amine catalysts such as 1,8-diazabicyclo (5,4,0) undecene and the like; phosphorus catalyst such as triphenylphosphine and the like. Among these, imidazoles are preferable, in view of providing a compatibility of the rapid curability and the storage stability of the adhesive film for the semiconductor element.

The above-described imidazoles are not particularly limited, and typically includes, for example: 1-benzil-2 methyl imidazole, 1-benzil-2 phenylimidazole, 1-cyanoethyl-2-ethyl-4-methyl imidazole, 2-phenyl 4 - methyl imidazole, 1-cyanoethyl-2-phenylimidazolium trimelitate, 2,4- diamino-6-[2'-methyl imidazolyl-(1')]-ethyl-s-triazine, 2,4- diamino-6-[2'-undecyl imidazolyl-(1')]-ethyl-s-triazine, 2,4- diamino-6-[2'-ethyl-4' methyl imidazolyl-(1')]-ethyl-s-triazine, isocyanuric acid-adduct of 2,4- diamino-6-[2'-methyl imidazolyl-(1')]-ethyl-s-triazine, 2-phenylimidazole isocyanuric acid-adduct, 2-phenyl-4,5-dihydroxymethyl imidazole, 2-phenyl-4-methyl-5-hydroxymethylimidazole, 2,4-diamino-6-vinyl-s-triazine, isocyanuric acid-adduct of 2,4-diamino-6-vinyl-s-triazine, 2,4-diamino-6-methacryloyloxyethyl-s-triazine, isocyanuric acid-adduct of 2,4-diamino-6-methacryloyloxyethyl-s-triazine, and the like. Among these, 2-phenyl-4,5-dihydroxymethyl imidazole or 2-phenyl-4-methyl-5-hydroxymethylimidazole are preferable, in view of well balanced nature of the rapid curability and the storage stability.

The content of the above-described curing catalyst is not particularly limited, and is preferably 0.01 to 30 parts by weight for 100 parts by weight of the above-described epoxy resin, and more preferably 0.5 to 10 parts by weight. The content within the above-described range provides a compatibility of the rapid curability and the storage stability of the above-described adhesive layer.

The mean particle diameter of the above-described curing catalyst is not particularly limited, and is preferably equal to or smaller than 10 μm, and more preferably 1 to 5 μm.
The mean particle diameter within the above-described range ensures the rapid curability of the above-described adhesive layer.

The varnish used for the adhesive film for the semiconductor element of the present invention may preferably

further contain a coupling agent, though it is not particularly limited thereto. This allows providing further improved adhesiveness in the interface between the adhesive film for the semiconductor element and a adhered member (semiconductor element, substrate for installing the semiconductor element). The above-described coupling agent typically includes, for example, silane coupling agent, titanium coupling agent, aluminum coupling agent and the like, and the silane coupling agent is preferable, in view of better thermal resistance of the cured product of the adhesive film for the semiconductor element.

The above-described silane coupling agent is not particularly limited, and typically includes, for example, vinyl trichlorosilane, vinyl trimethoxysilane, vinyl triethoxysilane, β-(3,4 epoxy cyclohexyl) ethyl trimethoxysilane, γ-glycidoxypropyltrimethoxysilane, γ-glycidoxy propyl methyl dimethoxy silane, γ-methacryloxy propyl trimethoxysilane, γ-methacryloxy propylmethyldiethoxysilane, γ-methacryloxy propyltriethoxysilane, N-β (amino ethyl) γ - aminopropyl methyldimethoxysilane, N-β (amino ethyl) γ-aminopropyltrimethoxysilane, N-β (amino ethyl) γ-aminopropyl triethoxysilane, γ-aminopropyltrimethoxysilane, γ-aminopropyl triethoxysilane, N-phenyl-γ-aminopropyltrimethoxysilane, γ-chloropropyl trimethoxysilane, γ-mercaptopropyl trimethoxysilane, 3-isocyanate propyltriethoxysilane, 3-acryloxypropyl trimethoxysilane and the like.

The content of above-described coupling agent is not particularly limited, and 0.01 to 10 parts by weight for 100 parts by weight of the non-volatile component contained in the above-described varnish used for the adhesive film for the semiconductor element is preferable, and 0.5 to 10 parts by weight is particularly preferable. The content within the above-described range allows enhanced adhesiveness between the adhered members (semiconductor element, substrate for installing the semiconductor element).

The elastic modulus of the adhesive film for the semiconductor element at 175 degrees C according to the present invention is not particularly limited, and is preferably equal to or higher than 30 MPa and equal to or lower than 140 MPa, and more preferably equal to or higher than 40 MPa and equal to or lower than 120 MPa. The elastic modulus within the above-described range provides improved filling-ability for a step in the circuit board or the semiconductor element, and ensures the mechanical strength required for the wire bonding.

The measuring method for the elastic modulus at 175 degrees C of the adhesive film for the semiconductor element is as follows.

A dynamic viscoelasticity of the adhesive layer of the adhesive film for the semiconductor element of the present invention is measured with a dynamic viscoelasticity device commercially available from SEIKO Instrument Co. Ltd., in temperature dependant measurement mode under the condition of a frequency of 10 Hz and heated at a temperature ramp rate 5 degrees C/min from the normal temperature, to determine the storage elastic modulus at 175 degrees C.

The varnish used for the adhesive film for the semiconductor element of the present invention may contain additives such as plastic resin, leveling agent, antifoaming agent, organic peroxide and the like, as far as it does not deteriorate the object of the present invention.

The compound constituting the adhesive film for the semiconductor element such as the above-mentioned the compound (A), the compound (B) and the like is dissolved or dispersed in an organic solvent such as, for example, methylethyl ketone, acetone, toluene, dimethyl formaldehyde and the like to be a varnish-like condition for the varnish used for the adhesive film for the semiconductor element of the present invention. The varnish used for the adhesive film for the semiconductor element in the varnish-like condition is formed to a layer-like shape, and then the solvent is removed and dried to form the film-shape of the above-described the varnish used for the adhesive film for the semiconductor element.

## 2. The Adhesive Film for The Semiconductor Element

The adhesive film for the semiconductor element of the present invention includes a base material film and an adhesive layer formed on the surface of the base material film, and is preferably composed of the base material film and the adhesive layer. In addition, the adhesive layer is formed to be film-shaped.

The composition of the adhesive layer of the adhesive film for the semiconductor element of the present invention is similar to the composition of the varnish used for the adhesive film for the semiconductor element, except that the above-described organic solvent is not included therein.

The above-described adhesive layer is not particularly limited, and may be obtained by coating the base material film with the varnish used for the adhesive film for the semiconductor element of the present invention with a comma bar coater, a die coater, a gravure coater and the like, and then drying the film to remove the solvent. The thickness of the above-described adhesive layer is not particularly limited, and the thickness of equal to or larger than 3 μm and equal to or smaller than 100 μm is preferable, and in particular the thickness of equal to or larger than 5 μm and equal to or smaller than 70 μm is more preferable. The thickness within the above-described range provides improved controllability of the thickness accuracy of the adhesive layer.

The above-described base material film is a film support base material having film characteristics for maintaining the film state of the adhesive layer, namely, for example, better breaking strength and better flexibility, and is typically

made of, for example, polyethylene terephthalate (PET), polypropylene (PP), polyethylene (PE) and the like, and among these, preferably made of polypropylene (PP) or polyethylene terephthalate (PET), in view of well balanced nature of the flexibility and the breaking strength.

The composite adhesive film for the semiconductor element of the present invention may be provided with a dicing function for fixing the adhesive layer, and the process for manufacturing the composite adhesive film for the semiconductor element provided with the dicing function are as follows.

An outer circumference of an effective region of the above-described adhesive layer 2 of the adhesive film 20 for the semiconductor element, which is composed of a base material film I 1 having a circular plan view geometry and the adhesive layer 2 as shown in Fig. 1, is removed along a ring to obtain a first stacked-layer member 30 show in Fig. 2. Here, the effective region is a region for bonding the semiconductor wafer having the employed semiconductor element mounted thereon.

Next, the adhesive layer 2 of the first stacked-layer member 30 is stacked with a stacked-adhesive layer member 40 composed of a base material film II 3 and an adhesive layer 4 stacked as shown in Fig. 3 so as to be adjacent to the adhesive layer 4 to obtain a composite adhesive film A50 for the semiconductor element (Fig. 4).

Alternatively, the composite adhesive film for the semiconductor element may be obtained by the following method.

The adhesive layer 2 of the adhesive film 10 for the semiconductor element, which is composed of the base material film I 1 and the adhesive layer 2 stacked thereon as shown in Fig. 1,
is stacked with the first stacked-adhesive layer member 60, which is composed of a base material film III 5 and a first adhesive layer 6 stacked thereon as shown in Fig. 5, so as to be adjacent to the first adhesive layer 6 so obtain a second stacked-layer member 70 (Fig. 6).

Next, for the above-described second stacked-layer member 70, the outer circumferences of the effective regions of the above-described base material film III 5, the above-described first adhesion layer 6 and the above-described adhesive layer 2 are removed along a ring, while the entire base material film I 1 is remained to obtain a third stacked-layer member 80 show in Fig. 7.

Next, the base material film III 5 of the above-described third stacked-layer member 80 is stripped, and then, a base material film IV 7 and a second adhesive layer 8 of a second stacked-adhesive layer member 90, which is composed of the second adhesion layer 8 having a viscosity that is larger than the viscosity of the first adhesive layer stacked thereon as shown in Fig. 8 is stacked with the first adhesive layer 6 so as to be adjacent to the first adhesive layer 6 to obtain the composite adhesive film for the semiconductor element B100 provided with the dicing function as shown in Fig. 9. Further, as shown in Fig. 10, an adhesive layer 10 may be deposited on a base material film 9 to obtain a dicing sheet 110.

Thus, the composite adhesive film for the semiconductor element of the present invention is composed of the adhesive film for the semiconductor element of the present invention and the dicing film. Here, the films shown in Fig. 3, Fig. 5, Fig. 8 and Fig. 10 are the dicing film.

Next, a process for manufacturing the semiconductor device will be described. Fig. 11 is an example of a flow chart for manufacturing a semiconductor device employing the adhesive film for the semiconductor element provided with no dicing function.
As shown in Fig. 11, the semiconductor device is manufactured by conducting: a semiconductor wafer dicing operation for dicing the semiconductor wafer having semiconductor elements installed therein into units of the respective semiconductor elements (hereinafter referred to as "semiconductor chips"); a pickup operation for picking up the semiconductor chips; an operation of bonding the adhesive film for the semiconductor element, for bonding the adhesive film for the semiconductor element over the picked semiconductor chip; a temporary adhesion operation for temporarily adhering the semiconductor chip with the circuit board or the semiconductor chip with another semiconductor chip by utilizing the adhesion layer of the adhesive film for the semiconductor element; a wire bonding operation for electrically coupling the semiconductor chips with the circuit board; an encapsulating operation for encapsulating the semiconductor chips and the bonding wires with an encapsulating resin; and cure operation for curing the encapsulating resin and the adhesive film for the semiconductor element.

Each of the above-described operation will be described in detail below.

(Semiconductor Wafer Dicing Operation)

With a semiconductor wafer dicing operation, as shown in Fig. 12-a, the semiconductor wafer 11 having semiconductor elements installed therein is bonded to the dicing sheet 110, which includes the adhesive layer 10 stacked on the base material film 9, and then, as shown in Fig. 12-b, a wafer ring 13 serving as a support member is bonded to the circumference of the semiconductor wafer 11. The wafer ring 13 is fastened to the adhesive layer 10 of the dicing sheet. Then, as shown in Fig. 12-c, the semiconductor wafer 11 is diced into the respective pieces from the side of the semiconductor wafer surface with a blade of a dicing device. In this regard, the cutting is further proceeded to the

substantially half of the thickness of the adhesive layer 10 along the thickness direction.

(Pickup Operation)

Next, as shown in Fig. 12-d, the adhesive film for the semiconductor element is stretched with an expanding device in order to allow the respective diced semiconductor chips 12 being picked up to provide certain intervals between the semiconductor chips 12. Then, as shown in Fig. 12-e, the semiconductor chips 12 are picked up.

(Operation of Bonding The Adhesive Film for The Semiconductor Element)

Further, in the operation of bonding the adhesive film for the semiconductor element, as shown in Fig. 12-f, the adhesion layer 2 of the adhesive film for the semiconductor element 20 is adhered over the picked semiconductor chips 12.

(Temporary Adhesion Operation)

More specifically, in the temporary adhesion operation, the circuit board, the adhesive film for the semiconductor element, and the semiconductor element are stacked in this sequence, and a thermo-compression bonding is conducted to provide a temporary adhesion of the semiconductor element with the circuit board. Such temporary adhesion may be carried out by conducting the thermo-compression bonding under the condition of, for example, at a temperature of 80 degrees C to 150 degrees C, with a load of 1 N to 20 N, and for duration time of 0.1 second to 5 seconds, by employing a die bonding device (commercially available from ASM under the trade name of AD898). Then, in order to prevent a breakdown of the semiconductor element, the thermo-compression bonding is preferably conducted at a lower temperature, with a lower load and for a shorter duration time, and thus it is difficult to completely fill the irregularity on the circuit board with the adhesive film for the semiconductor element in such operation, and therefore a space presented between the circuit board and the adhesive film for the semiconductor element may be allowable.

Recently, it is common to have plural stacks of the semiconductor elements for the requirements of high-density assembly and high integration of semiconductor devices, and the configuration of the the present invention may be employed for the above-described configuration, in which an additional semiconductor element is temporarily adhered over the semiconductor elements that has been temporarily adhered.

(Wire Bonding Operation)

In the wire bonding operation, an electrode of the semiconductor element is electrically coupled to an electrode of the circuit board to with a bonding wire. Such coupling of the bonding wire may be carried out by, for example, employing a wire bonding device (commercially available from ASM under the trade name of EAGLE 60) at a temperature of 150 degrees C to 200 degrees C.

In the semiconductor device having two or more stacks of the semiconductor elements, the wire bonding operation for the first stack of the semiconductor element may be conducted, and then the temporary adhesion operations and the wire bonding operations for the second and further stacks may be similarly repeatedly conducted over formerly temporary adhered and wire bonded semiconductor element.

(Encapsulating Operation)

In the encapsulating operation, an encapsulation with an encapsulating resin is conducted to cover the semiconductor elements and the bonding wires that join the electrodes of the circuit board with the electrodes of the semiconductor elements. This allows providing improved electrical insulation and moisture proof. The conditions for providing the encapsulation are, for example, at a high temperature of 150 to 200 degrees C and at a high pressure of 50 to 100 $kg/mm^2$, by employing a transfer molding apparatus. Besides, the adhesive film for the semiconductor element is softened at the same time of the encapsulation with the encapsulating resin to achieve the complete filling of the irregularity on the circuit board.

In the case of requiring longer thermal history in the wire bonding operation for the multiple stacks of the semiconductor elements, the use of the conventional adhesive film for the semiconductor element causes a progress of the cure of the adhesive film for the semiconductor element to cause a reduced flowability of the film, whereby possibly causing a detect of incomplete filling of the irregularity in the surface of the circuit board. The above-described failure can be avoided by adopting the adhesive film for the semiconductor element of the present invention.

(Cure Operation)

In the cure operation, the encapsulating resin is cured and the adhesive film for the semiconductor element is also cured. This allows obtaining the finished product of the semiconductor device. The cure condition is not particularly limited provided that the condition provides the cure of the encapsulating resin and the adhesive film for the semiconductor element, and for example, a condition at a temperature of 100 to 200 degrees C and a duration time of 5 to 300 minutes is preferable, and in particular a condition at a temperature of 120 to 180 degrees C and a duration time of 30 to 240 minutes is more preferable.

The semiconductor device 200 as shown in Fig. 15 can be eventually obtained through such process operations. The semiconductor device 200 according to the present invention includes: a multiple layer-stacked semiconductor element (first semiconductor element 121 and second semiconductor element 122); a substrate (circuit board 120) having the multiple layer-stacked semiconductor element (first semiconductor element 121 and second semiconductor element 122) installed therein; and an adhesion layer 2 provided between a semiconductor element (first semiconductor element 121) and another semiconductor elements (second semiconductor element 122) or between a semiconductor element (first semiconductor element 121) and a substrate (circuit board 120). Such adhesion layer 2 is a cured product of the adhesive film for the semiconductor element or the composite adhesive film for the semiconductor element according to the present invention. Further, the semiconductor device 200 according to the present invention includes a first bonding wire 123, a second bonding wire 124, a terminal 125 formed in a functional surface of the first semiconductor element, a terminal 126 formed in a functional surface of the second semiconductor element, and an encapsulating resin 127. The adhesive film for the semiconductor element or the composite adhesive film for the semiconductor element of the present invention may provide an adhesion of the semiconductor chip with the lead frame.

Fig. 13 is a flow chart, which presents an example of a flow of a manufacture of a semiconductor device in an embodiment, in which an adhesive film for the semiconductor element having dicing function is employed. As shown in Fig. 13, the semiconductor device may be manufactured by conducting: an operation of bonding the adhesive film for the semiconductor element, for bonding the adhesive film for the semiconductor element over the semiconductor wafer having semiconductor elements installed therein; a semiconductor wafer dicing operation for dicing the semiconductor wafer into units of the respective semiconductor chips; a pickup operation for picking the semiconductor chips with the adhesive films for the semiconductor element; a temporary adhesion operation for temporarily adhering the semiconductor chip with the circuit board or the semiconductor chip with another semiconductor chip by utilizing the adhesion layer of the adhesive film for the semiconductor element; a wire bonding operation for electrically coupling the semiconductor chips with the circuit board; an encapsulating operation for encapsulating the semiconductor chips and the bonding wires with an encapsulating resin; and cure operation for curing the encapsulating resin and the adhesive film for the semiconductor element.

Each of the above-described operation will be described in detail below.

(Operation of Bonding The Semiconductor Wafer)

The operation for bonding the semiconductor wafer is an operation for bonding the semiconductor wafer 11 having semiconductor element installed therein to the adhesion layer 2 of the above-mentioned the composite adhesive film B100 for the semiconductor element as shown in Fig. 14-a. In such bonding operation, the composite adhesive film B100 for the semiconductor element is disposed on a dicer table of the dicing device that provides the dicing of the semiconductor wafer 11, in the condition that the adhesion layer 2 is turned up. Next, the surface of the semiconductor wafer 11, opposite to the surface including the semiconductor element installed therein, is placed so as to be adjacent to the above-described adhesion layer 2 to bond the semiconductor wafer 11 to the adhesion layer 2.

(Dicing Operation)

Next, as shown in Fig. 14-b, the wafer ring 13 serving as a support member is bonded to the circumference of the adhesion layer 2. At this time, the wafer ring 13 is fastened to the second adhesive layer 8. Then, as shown in Fig. 14-c, the semiconductor wafer 11 is diced into the respective pieces from the side of the semiconductor wafer surface with a blade of a dicing device. In this regard, the cutting is further proceeded to the substantially half of the thickness of the first adhesive layer 6 along the thickness direction.

(Pickup Operation)

Next, as shown in Fig. 14-d, the adhesive film for the semiconductor element an adhesive film for the semiconductor element with a dicing sheet is stretched with an expanding device in order to allow the respective diced semiconductor chips 12 being picked up to provide certain intervals between the semiconductor chips 12. Then, as

shown in Fig. 14-e, the semiconductor chips 12 with the adhesion layers 2 are picked up, and then are installed on the circuit board and the semiconductor element.

The operations on and after the temporary adhesion operation are similar to that for employing the above-mentioned adhesive film for the semiconductor element.

While an example of a process for manufacturing the semiconductor device in the case that the adhesive film for the semiconductor element and the composite adhesive film for the semiconductor element having the dicing function are employed have been described in the present description, the process for manufacturing the semiconductor device employing the adhesive film for the semiconductor element of the present invention is not particularly limited to any specific process, and for example, the adhesion layer of the adhesive film for the semiconductor element may be bonded to the semiconductor wafer, and then the dicing and the picking up may be conducted to be installed in the circuit board and/or the semiconductor element.

In addition to above, the configuration of the semiconductor device is not limited to the configuration illustrated here, and any types of semiconductor devices may be employed, provided that the device has a structure, in which the semiconductor element is adhered to a material to be adhered with an adhesive film for the semiconductor element.

While the preferred embodiments of the present invention have been described above in reference to the annexed figures, it should be understood that the disclosures above are presented for the purpose of illustrating the present invention, and various modifications other than that described above are also available. For example, a process for applying the varnish for the manufacture of the adhesive film for the semiconductor element of the present invention over the substrate or the semiconductor wafer so as to achieve the target thickness of the adhesion film obtained after the drying process, and then drying the varnish to remove the solvent to obtain the adhesive film for the semiconductor element, or the like.

The present invention is further described on the basis of an example and a comparative example in detail below, and the present invention is not limited thereto.

[Example 1]

(Preparation of Resin Varnish)

100 parts by weight of (meth) acrylic ester copolymer (A) under the trade name of SG-708-6DR (ethylacrylate/butylacrylate/acrylonitrile/hydroxyethyl methacrylate/acrylic acid copolymer = 46.1 mol % /16.6 mol % /33.5 mol % /1.3 mol %/2.5 mol %; commercially available from Nagase Chemtex Corporation; glass transition temperature Tg: 6 degrees C, weight-average molecular weight: 500,000) and 500 parts by weight of silica (B) of organo silicasol under the trade name of PL-2L-MEK (silica having specific surface area-converted particle diameter of 16 nm in methylethyl ketone (hereinafter referred to as MEK) at a concentration of 20 mass %, commercially available from Fuso Chemical Co., Ltd.) were dissolved in MEK to obtain a resin varnish at a resin solid content of 20 %.

(Manufacture of The Adhesive Film for The Semiconductor Element)

The resin varnish obtained with above-described method was applied with a comma bar coater over a polyethylene terephthalate film (commercially available from DuPont Teijin Films Co., Ltd. under the trade name of PUREX A54, thickness 38 μm), which serves as a base material film when an adhesive film for the semiconductor element with a dicing sheet is manufactured, and then the film was dried at 150 degrees C for three minutes to obtain the adhesive film for the semiconductor element having a thickness of 25 μm.

(Manufacture of First Stacked-Adhesive Layer Member)

100 parts by weight of a copolymer (A) having a weight-average molecular weight of 300,000, which is obtained by copolymerizing 30 mass % of 2-ethylhexyl acrylate and 70 mass % of vinyl acetate, 45 parts by weight of pentafunctional acrylate monomer having a molecular weight of 700 (commercially available from Nippon Kayaku Co., Ltd. under the trade name of KAYARAD D-310), 5 parts by weight of 2,2-dimethoxy-2-phenylacetophenone and 3 parts by weight of tolylene diisocyanate (commercially available from Nippon Polyurethane Co., LTD. under the trade name of CORONATE T -100) were dissolved in MEK to obtain a resin varnish at a resin solid content of 20 %. The above-described resin varnish was applied over a strip-processed polyester film of a thickness of 38 μm with a comma bar coater so as to obtain a thickness of 10 μm of the resin varnish after the drying process, and then the varnish was dried at 80 degrees C for five minutes. Then, an ultraviolet radiation of 500 mJ/cm$^2$ was applied to obtain the first stacked-adhesive layer member having the base material film II stacked with the first adhesive layer. Such adhesive layer of the first stacked-adhesive layer member was stacked over the adhesion layer of the adhesive film for the semiconductor element so that the adhesive layer be adjacent to the adhesion layer to obtain the first stacked-layer member.

(Manufacture of The Second Stacked-Adhesive Layer Member)

A film having a thickness of 100 μm serving as a base material film III was formed with an extruder apparatus by employing CLEARTEC CT-H717 (commercially available from Kuraray) composed of 60 parts by weight of HYBRAR (commercially available from Kuraray) and 40 parts by weight of polypropylene, and then the surface of the film was treated with a corona treatment. Next, a copolymer having a weight-average molecular weight of 500,000 obtained by copolymerization with 50 parts by weight of 2-ethylhexyl acrylate, 10 parts by weight of butyl acrylate, 37 parts by weight of vinyl acetate and 3 parts by weight of 2-hydroxyethyl methacrylate was applied over a strip-processed polyester film of a thickness of 38 μm so as to obtain a thickness of 10 μm of the resin varnish after the drying process, and then the varnish was dried at 80 degrees C for five minutes to obtain the second adhesive layer. Then, the second adhesive layer was laminated over the corona treated surface of the base material film III to obtain the second stacked-adhesive layer member, which is composed of the base material film III, the second adhesive layer and the polyester film stacked in this sequence.

(Manufacture of the Composite Adhesive Film for the Semiconductor Element)

The base material film II of the first stacked-layer member was stripped, and then, ring-shaped sections of the first adhesive layer and the adhesive layer are removed by cutting such ring-shaped sections from the side of the first adhesive layer to the substantially half of the thickness of the base material film I along the thickness direction to leave a section having a dimension that is larger than a dimension represented by the outer diameter of the semiconductor wafer to be bonded thereto. Further, the polyester film was stripped from the second stacked-adhesive layer member, and the second adhesive layer is bonded to the first adhesive layer so as to be mutually adjacent. As described above, the composite adhesive film for the semiconductor element, which is composed of the base material film III, the second adhesive layer, the first adhesive layer, the adhesive layer and the base material film I, stacked in this sequence, can be obtained.

(Method of Measuring the Elastic Modulus at 175 degrees C)

A dynamic viscoelasticity of the adhesive layer of the adhesive film for the semiconductor element produced in Example 1 is measured with a dynamic viscoelasticity device commercially available from SEIKO Instrument Co. Ltd., in temperature dependant measurement mode under the condition of a frequency of 10 Hz and heated at a temperature ramp rate 5 degrees C/min from the normal temperature, to determine the storage elastic modulus at 175 degrees C.

(Evaluation on Wire Bonding Capability)

The adhesive layer of the adhesive film for the semiconductor element obtained in Example 1 was sandwiched between a silicon chip (thickness 100 μm) provided with an aluminum layer having a dimension of 3.5 mm x 3.5 mm via a deposition process and a circuit board of a bismaleimide-triazine resin (circuit step: 5 to 10 μm) having a coating of a solder resist (commercially available from Taiyo Ink Mfg. Co., Ltd. under the trade name of AUS308) formed thereon, and then a thermo-compression bonding was conducted at 130 degrees C with 5N and for one second to obtain a sample for evaluating the wire bonding capability.

A wire bonding process was conducted for the above-described sample with a wire bonder device commercially available from ASM at 175 degrees C, and then a feature of a ball formed on the silicon chip was evaluated with an optical microscope, and an adhesive strength of the ball formed on the silicon chip with the aluminum surface on the silicon chip was evaluated with a ball shear tester device. Respective marks indicate the following conditions.

○: a ball is formed to be spherical and the ball shear strength is equal to or higher than 7 $kgf/mm^2$

×: a ball is formed to be non-spherical or the ball shear strength is equal to or lower than 7 $kgf/mm^2$

(Manufacture of the Semiconductor Device)

A semiconductor device shown in Fig. 15 was manufactured by the following procedure.

The adhesive layer of the adhesive film for the semiconductor element with the dicing sheet obtained in Example 1 was opposed to a back surface of a 200 μm-thick 8-inch semiconductor wafer, and these were bonded at a temperature of 60 degrees C to obtain the semiconductor wafer having the composite adhesive film for the semiconductor element bonded thereto.

Then, such semiconductor wafer having the composite adhesive film for the semiconductor element bonded thereto was diced into semiconductor chips having a dimension of 10 mm x 10 mm square by employing a dicing device at a spindle rotating speed of 30,000 rpm and a dicing speed of 50 mm/sec. Then, the chip was knocked from the side

of the base material film III of the composite adhesive film for the semiconductor element to cause a delamination of the adhesive film for the semiconductor element from the first adhesive layer, thereby obtaining a semiconductor chip with the adhesive layer.

Such semiconductor chip with the adhesive layer (10 mm x 10 mm square, circuit step of element surface: 1 to 5 μm) was bonded to a circuit board of a bismaleimide-triazine resin (circuit step: 5 to 10 μm) having a coating of a solder resist (commercially available from Taiyo Ink Mfg. Co., Ltd. under the trade name of AUS308) formed thereon via a thermo-compression bonding at 130 degrees C with 5N and for one second to achieve a temporary adhesion of the semiconductor chip with the circuit board of the bismaleimide-triazine resin. The semiconductor chip with the adhesive layer produced similarly to have a dimension of 7 mm x 7 mm square was thermo-compression bonded over such temporary adhered semiconductor chip under the condition at 130 degrees C with 5N and for one second, so that two semiconductor chip with different dimensions were stacked over the bismaleimide-triazine resin circuit board to provide a dual-stack configuration.

Then, a thermal processing at 175 degrees C for one hour was conducted, by assuming a thermal history for a wire bonding process for stacking multiple layers of the semiconductor chips. Then, an encapsulation was carried out with an encapsulating resin (commercially available from Sumitomo Bakelite Co. ,Ltd., under the trade name of EME-G770) by employing a low pressure transfer molding machine under the condition at a molding temperature of 175 degrees C, at a pressure of 70 kg/cm$^2$, and with a curing time of two minutes, and then a thermal processing at 175 degrees C for two hours was carried out to completely cure the encapsulating resin, thereby obtaining ten semiconductor devices.

(Filling-Ability for the Steps on the Circuit Board)

The filling-ability for the steps on the circuit board was presented by calculating a rate of dimensional area of the section of the adhesive layer, which fills the adhesive section of the circuit board without a void for the semiconductor device obtained in Example 1 with a scanning acoustic tomography (SAT) with the following formula:

filling rate (%) = (dimensional area of the section filling without void)/ (dimensional area of the adhesive surface of the circuit board) x 100

Respective marks indicate the following conditions, and the filling rate of equal to or higher than 80 % indicates that the reliability of the semiconductor device is of no matter.
○: the filling rate is equal to or higher than 80 % and equal to or lower than 100 %; and
×: the filling rate is lower than 80 %, or the entire inner surface of the adhesive layer includes voids.

(Crack Resistance)

The crack resistance was evaluated by conducting a moisture absorption treatment for the semiconductor device obtained in Example 1 under the condition of 85 degrees C/ relative humidity (RH) of 60 % / 168 hours, and then conducting three cycles of infra red reflow process at 260 degrees C to determine a presence of a crack with a scanning acoustic tomography (SAT). Respective marks indicate the following conditions.
○: no crack in ten
×: one or more crack in ten

[Example 2]

The manufacture of the composite adhesive film for the semiconductor element and the respective evaluations thereof were conducted similarly as in Example 1, except that 100 parts by weight of (meth) acrylic ester copolymer (A) under the trade name of SG-P3DR (ethylacrylate/butylacrylate/acrylonitrile/glycidyl methacrylate copolymer = 25.5 mol %/24.6 mol %/ 48.1 mol %/ 1.8 mol %; commercially available from Nagase Chemtex Corporation; Tg: 18 degrees C, weight-average molecular weight: 850,000) was employed, in place of 100 parts by weight of (meth) acrylic ester copolymer (A) of SG-708-6DR (ethylacrylate-butylacrylate-acrylonitrile-hydroxyethyl methacrylate-acrylic acid copolymer; commercially available from Nagase Chemtex Corporation; Tg: 6 degrees C, weight-average molecular weight: 500,000).

[Example 3]

The manufacture of the composite adhesive film for the semiconductor element and the respective evaluations thereof were conducted similarly as in Example 1, except that 100 parts by weight of spherical silica NSS-5N (mean particle diameter 70 nm, commercially available from TOKUYAMA Corporation) was employed , in place of silica (B) of organo silicasol PL-2L-MEK (silica having specific surface area-converted particle diameter of 16 nm in methylethyl ketone at a concentration of 20 mass %, commercially available from Fuso Chemical Co., Ltd.).

[Example 4]

The manufacture of the composite adhesive film for the semiconductor element and the respective evaluations thereof were conducted similarly as in Example 1, except that 2 parts by weight of a thermosetting resin of an epoxy resin EOCN-1020-80 (orthocreosol novolac epoxy resin, epoxy equivalent 200 g/eq, company commercially available from Nippon Kayaku Co., Ltd.) and 4 parts by weight of a curing agent of phenolic resin PR-HF-3 (hydroxyl equivalent 104g/OH, commercially available from Sumitomo Bakelite Co., Ltd.) were added therein. In addition to above, the component of the thermosetting resins composed of the epoxy resin and the phenolic resin is 2.9 mass % of the all non-volatile components.

[Example 5]

The manufacture of the composite adhesive film for the semiconductor element and the respective evaluations thereof were conducted similarly as in Example 1, except that 100 parts by weight of (meth) acrylic ester copolymer of SG-80HDR (ethylacrylate/acrylonitrile/glycidyl methacrylate/N, N dimethylacrylamide copolymer = 63.0 mol %/32.1 mol %/0.6 mol mol %/4.3 mol %; commercially available from Nagase Chemtex Corporation; Tg: 18 degrees C, weight-average molecular weight: 350,000) was employed, in place of 100 parts by weight of (meth) acrylic ester copolymer (A) of SG-708-6DR (ethylacrylate-butylacrylate-acrylonitrile-hydroxyethyl methacrylate-acrylic acid copolymer; commercially available from Nagase Chemtex Corporation; Tg: 6 degrees C, weight-average molecular weight: 500,000).

[Comparative Example 1]

The manufacture of the composite adhesive film for the semiconductor element and the respective evaluations thereof were conducted similarly as in Example 1, except that 100 parts by weight of acrylic ester copolymer A (ethylacrylate-butylacrylate-acrylonitrile- hydroxyethyl methacrylate copolymer, commercially available from Nagase Chemtex Corporation; Tg: 6 degrees C, weight-average molecular weight: 600,000) was employed, in place of 100 parts by weight of (meth) acrylic ester copolymer (A) of SG-708-6DR (ethylacrylate-butylacrylate-acrylonitrile-hydroxyethyl methacrylate-acrylic acid copolymer; commercially available from Nagase Chemtex Corporation; Tg: 6 degrees C, weight-average molecular weight: 500,000).

[Comparative Example 2]

The manufacture of the composite adhesive film for the semiconductor element and the respective evaluations thereof were conducted similarly as in Example 1, except that 100 parts by weight of acrylic ester copolymer B (ethylacrylate/butylacrylate/acrylonitrile copolymer; commercially available from Nagase Chemtex Corporation; Tg: 17 degrees C, weight-average molecular weight: 980,000) was employed, in place of 100 parts by weight of (meth) acrylic ester copolymer (A) of SG-708-6DR (ethylacrylate-butylacrylate-acrylonitrile-hydroxyethyl methacrylate-acrylic acid copolymer; commercially available from Nagase Chemtex Corporation; Tg: 6 degrees C, weight-average molecular weight: 500,000).

[Comparative Example 3]

The manufacture of the composite adhesive film for the semiconductor element and the respective evaluations thereof were conducted similarly as in Example 1, except that 100 parts by weight of spherical silica NSS-3N (mean particle diameter 130 nm, commercially available from TOKUYAMA Corporation) was employed.

[Comparative Example 4]

The manufacture of the composite adhesive film for the semiconductor element and the respective evaluations thereof were conducted similarly as in Example 1, except that 133.3 parts by weight of silica (B) contained in silica slurry

SC-1050-LC (average particle diameter 270 nm of silica, 75 mass % solution of MEK, commercially available from Admatechs Company Limited) was employed.

[Comparative Example 5]

The manufacture of the composite adhesive film for the semiconductor element and the respective evaluations thereof were conducted similarly as in Example 1, except that 7 parts by weight of a thermosetting resin of an epoxy resin EOCN-1020-80 (orthocreosol novolac epoxy resin, epoxy equivalent 200 g/eq, company commercially available from Nippon Kayaku Co., Ltd.) and 14 parts by weight of a curing agent of phenolic resin PR-HF-3 (hydroxyl equivalent 104g/OH, commercially available from Sumitomo Bakelite Co., Ltd.) were added therein. In addition to above, the component of the thermosetting resins composed of the epoxy resin and the phenolic resin is 9.5 mass % of the all non-volatile components.

The formulations (part by weight) of the obtained adhesive film for the semiconductor element and the respective evaluation results in the respective Examples and Comparative Examples are shown in Table 1.

[Table 1]

TABLE-1 (UNIT: PART BY WEIGHT)

| | | EXAMPLE 1 | EXAMPLE 2 | EXAMPLE 3 | EXAMPLE 4 | EXAMPLE 5 | COMPARATIVE EXAMPLE 1 | COMPARATIVE EXAMPLE 2 | COMPARATIVE EXAMPLE 3 | COMPARATIVE EXAMPLE 4 | COMPARATIVE EXAMPLE 5 |
|---|---|---|---|---|---|---|---|---|---|---|---|
| (METH) ACRYLIC ESTER COPOLYMER (A) | SG-708-6DR | 100 | | 100 | 100 | | | | 100 | 100 | 100 |
| | SG-P3DR | | 100 | | | | | | | | |
| | SG-80H | | | | | 100 | | | | | |
| | A | | | | | | 100 | | | | |
| | B | | | | | | | 100 | | | |
| SILICA (B) | PL-2L-MEK | 100 *1 | 100 *1 | | 100 *1 | 100*1 | 100 *1 | 100 *1 | | | 100 |
| | NSS-5N | | | 100 | | | | | | | |
| | NSS-3N | | | | | | | | 100 | | |
| | SC-1050-LC | | | | | | | | | 133.3 | |
| THERMOSETING RESIN | EOCN-1020-80 | | | | 2 | | | | | | 7 |
| | PR-HF-3 | | | | 4 | | | | | | 14 |
| ELASTIC MODULUB AT 175 DEGREES C (MPa) | | 96 | 109 | 44 | 115 | 104 | 24 | 22 | 25 | 17 | 154 |
| WIRE BONDING CAPABILITY | | ○ | ○ | ○ | ○ | ○ | × | × | × | × | ○ |

(continued)

| | EXAMPLE 1 | EXAMPLE 2 | EXAMPLE 3 | EXAMPLE 4 | EXAMPLE 5 | COMPARATIVE EXAMPLE 1 | COMPARATIVE EXAMPLE 2 | COMPARATIVE EXAMPLE 3 | COMPARATIVE EXAMPLE 4 | COMPARATIVE EXAMPLE 5 |
|---|---|---|---|---|---|---|---|---|---|---|
| **FILLING-ABILITY FOR STEPS ON CIRCUIT BOARD** | ○ | ○ | ○ | ○ | ○ | ○ | ○ | ○ | ○ | × |
| **CRACK RESISTANCE** | ○ | ○ | ○ | ○ | ○ | ○ | ○ | ○ | ○ | × |
| *1 - VALUES EQUIVALENT IN THEM8 OF SOLID COMPONENT | | | | | | | | | | |

## Claims

1. A resin varnish used for an adhesive film for semiconductor element, comprising:

   a (meth) acrylic ester copolymer (A); and
   a silica (B),
   wherein said (meth) acrylic ester copolymer (A) has a hydroxyl group and a carboxylic group, or has an epoxy group, and has a weight-average molecular weight of 100,000 to 1,000,000,
   wherein said silica (B) has mean particle diameter of 1 to 100 nm, and
   wherein none of a thermosetting resin and a curing agent (C) is contained in non-volatile components, or total contents of said thermosetting resin and said curing agent (C) in said non-volatile components is equal to or lower than 5 wt %.

2. The resin varnish used for the adhesive film for semiconductor element as set forth in claim 1, wherein said (meth) acrylic ester copolymer (A) is a random copolymer containing structural units represented in the following general formula (I), (II), (III), and (IV):

[formula 1]

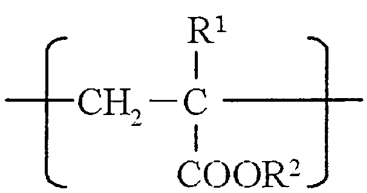 (I)

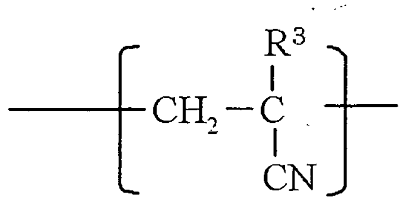 (II)

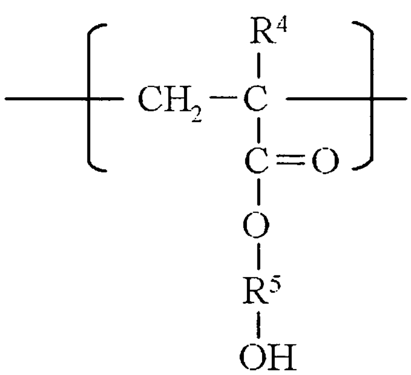 (III)

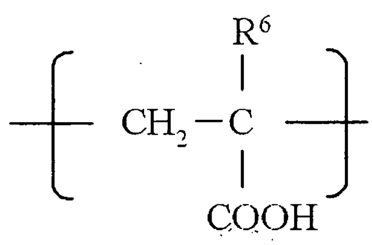 (IV)

(where each of $R^1$, $R^3$, $R^4$ and $R^5$ represents a hydrogen atom or a methyl group; $R^2$ represents an alkyl group having 1 to 10 carbon atoms; and $R^5$ represents an alkylene group having 1 to 10 carbon atoms).

3. The resin varnish used for the adhesive film for semiconductor element as set forth in claim 2, wherein molar ratio of the structural unit (I) is 30 to 88 mol %, molar ratio of the structural unit (II) is 10 to 68 mol %, molar ratio of the structural unit (III) is 1 to 10 mol %, and molar ratio of the structural unit (IV) is 1 to 10 mol %.

4. The resin varnish used for the adhesive film for semiconductor element as set forth in claim 1, wherein said (meth) acrylic ester copolymer (A) is a random copolymer containing structural units represented by the following general formula (V), (VI) and (VII):

[formula 2]

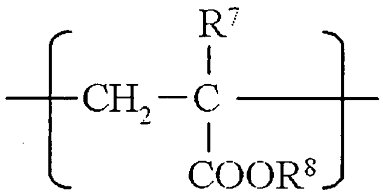 (V)

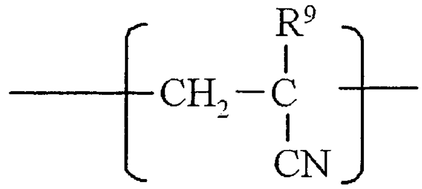 (VI)

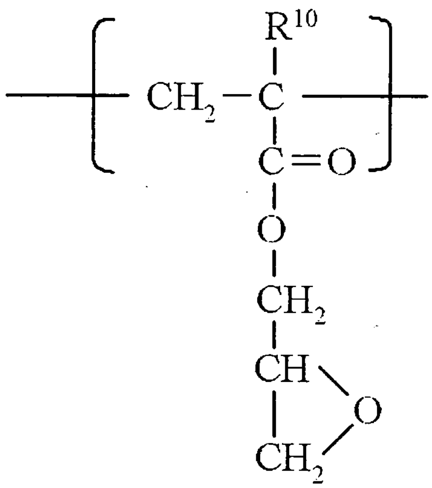 (VII)

(where each of $R^7$, $R^9$ and $R^{10}$ represents a hydrogen atom or a methyl group; and $R^8$ represents an alkyl group having 1 to 10 carbon atoms.)

**5.** The resin varnish used for the adhesive film for semiconductor element as set forth in claim 4, wherein molar ratio of the structural unit (V) is 30 to 88 mol %, molar ratio of the structural unit (VI) is 10 to 68 mol %, and molar ratio of the structural unit (VII) is 0.5 to 10 mol %.

**6.** The resin varnish used for the adhesive film for semiconductor element as set forth in claim 3, wherein a content of said silica (B) is 20 to 70 mass %.

**7.** The resin varnish used for the adhesive film for semiconductor element as set forth in claim 5, wherein a content of said silica (B) is 20 to 70 mass %.

**8.** The resin varnish used for the adhesive film for semiconductor element as set forth in claim 3, wherein the particle diameter of said silica (B) is 10 to 30 nm.

**9.** The resin varnish used for the adhesive film for semiconductor element as set forth in claim 5, wherein the particle diameter of said silica (B) is 10 to 30 nm.

**10.** An adhesive film for semiconductor element containing base material film and an adhesive layer, wherein the adhesive layer comprising:

a (meth) acrylic ester copolymer (A); and
a silica (B),
wherein said (meth) acrylic ester copolymer (A) has a hydroxyl group and a carboxylic group, or has an epoxy group, and has a weight-average molecular weight of 100,000 to 1,000,000,
wherein said silica (B) has mean particle diameter of 1 to 100 nm, and
wherein none of a thermosetting resin and a curing agent (C) is contained in non-volatile components, or total

contents of said thermosetting resin and said curing agent (C) in said non-volatile components is equal to or lower than 5 wt %.

**11.** The adhesive film for semiconductor element as set forth in claim 10, wherein said (meth) acrylic ester copolymer (A) is a random copolymer containing structural units represented in the following general formula (I), (II), (III), and (IV):

[formula 3]

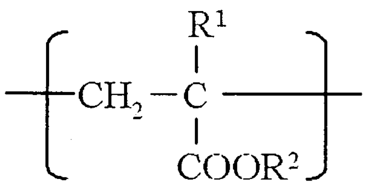
(I)

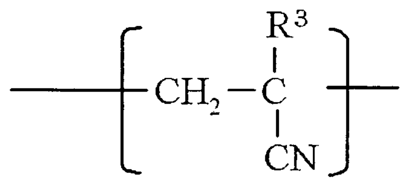
(II)

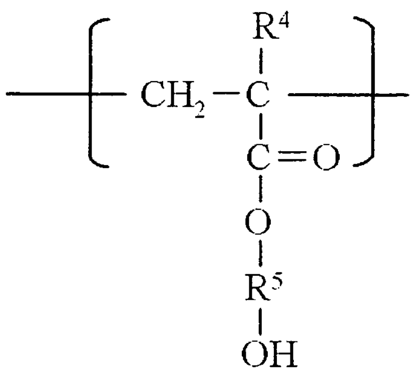
(III)

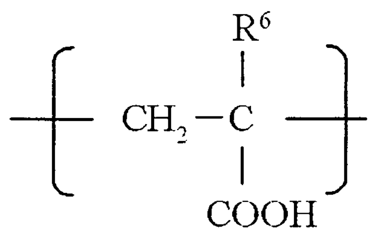
(IV)

(where each of $R^1$, $R^3$, $R^4$ and $R^6$ represents a hydrogen atom or a methyl group; $R^2$ represents an alkyl group having 1 to 10 carbon atoms; and $R^5$ represents an alkylene group having 1 to 10 carbon atoms).

**12.** The adhesive film for semiconductor element as set forth in claim 11, wherein molar ratio of the structural unit (I) is 30 to 88 mol %, molar ratio of the structural unit (II) is 10 to 68 mol %, molar ratio of the structural unit (III) is 1 to 10 mol %, and molar ratio of the structural unit (IV) is 1 to 10 mol %.

**13.** The adhesive film for semiconductor element as set forth in claim 10, wherein said (meth) acrylic ester copolymer (A) is a random copolymer containing structural units represented by the following general formula (V), (VI) and (VII);

[formula 4]

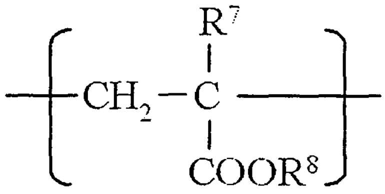

(V)

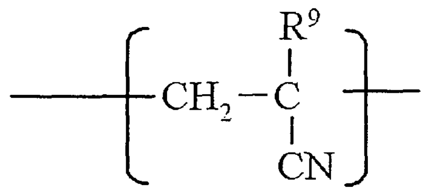

(VI)

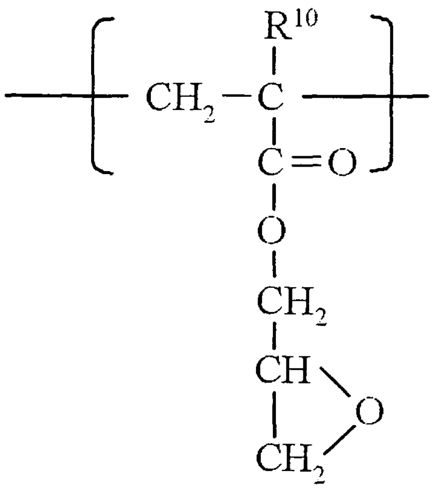

(VII)

(where each of $R^7$, $R^9$ and $R^{10}$ represents a hydrogen atom or an methyl group; and $R^8$ represents an alkyl group having 1 to 10 carbon atoms).

**14.** The adhesive film for semiconductor element as set forth in claim 13, wherein molar ratio of structural unit the (V) is 30 to 88 mol %, molar ratio of structural unit the (VI) is 10 to 68 mol %, and molar ratio of structural unit the (VII) is 0.5 to 10 mol %.

**15.** The adhesive film for semiconductor element as set forth in claim 12, wherein a content of said silica (B) is 20 to 70 mass % in said adhesive layer.

**16.** The adhesive film for semiconductor element as set forth in claim 14, wherein a content of said silica (B) is 20 to 70 mass % in said adhesive layer.

**17.** The adhesive film for semiconductor element as set forth in claim 12, wherein the particle diameter of said silica (B) is 10 to 30 nm.

**18.** The adhesive film for semiconductor element as set forth in claim 14, wherein the particle diameter of said silica (B) is 10 to 30 nm.

**19.** The adhesive film for semiconductor element as set forth in claim 12, wherein an elastic modulus at of 175 degrees C is within a range of between not less than 30 MPa and not more than 140 MPa.

**20.** The adhesive film for semiconductor element as set forth in claim 14, wherein an elastic modulus at of 175 degrees C is within a range of between not less than 30 MPa and not more than 140 MPa.

**21.** A composite adhesive film for semiconductor element, comprising: an adhesive film for semiconductor element as set forth in claim 12; and a dicing film.

**22.** A composite adhesive film for semiconductor element, comprising an adhesive film for semiconductor element as set forth in claim 14; and a dicing film.

**23.** A semiconductor device, comprising:

a semiconductor element composed of stacked multiple layers
a substrate provided with said semiconductor element composed of stacked multiple layers; and
an adhesive layer provided between said semiconductor element and said semiconductor element or between said semiconductor element and said substrate,
wherein said adhesive layer is a cured material of the adhesive film for the semiconductor element as set forth in claim 12.

**24.** A semiconductor device, comprising:

a semiconductor element composed of stacked multiple layers
a substrate provided with said semiconductor elements composed of stacked multiple layers; and
an adhesive layer provided between said semiconductor element and said semiconductor element or between said semiconductor element and said substrate,
wherein said adhesive layer is a cured material of the adhesive film for the semiconductor element as set forth in claim 14.

FIG. 1

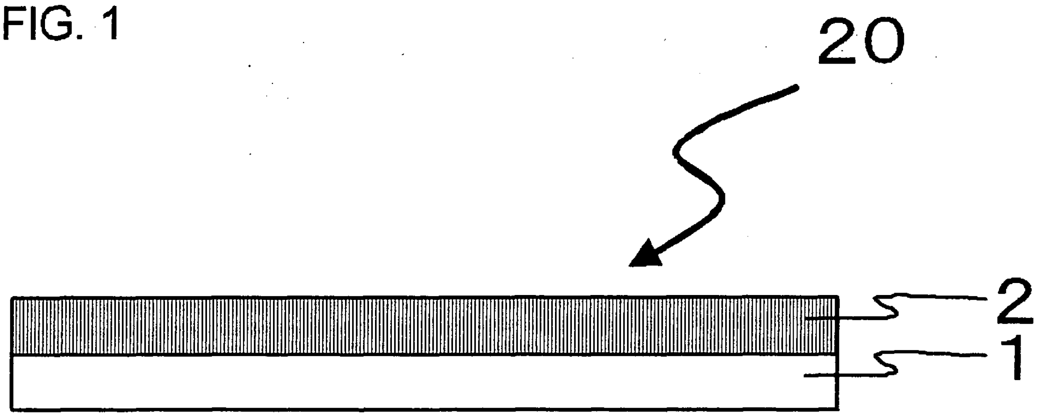


FIG. 2

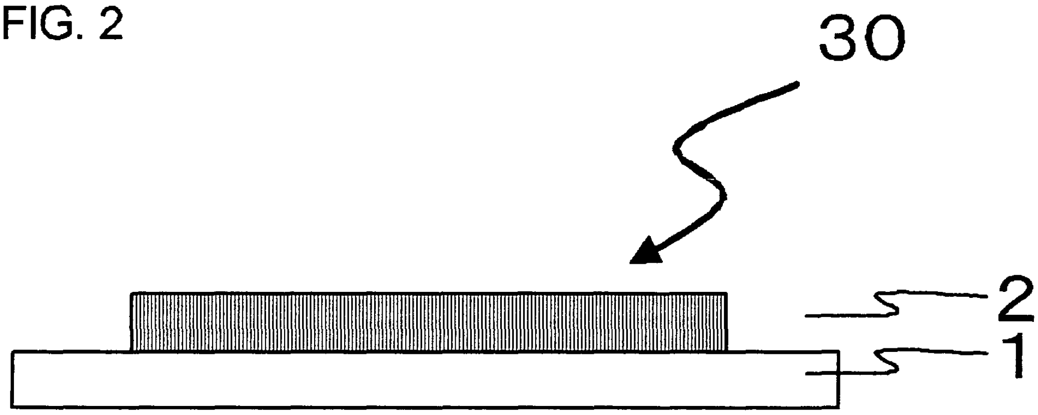


FIG. 3

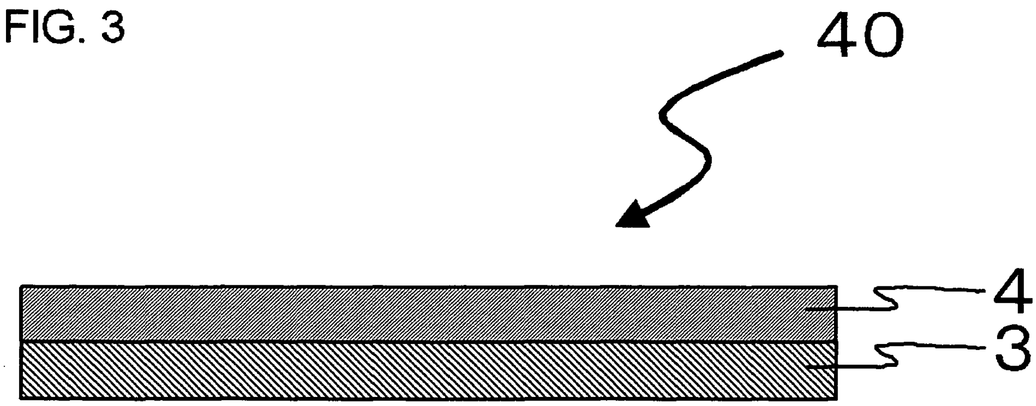

FIG. 4

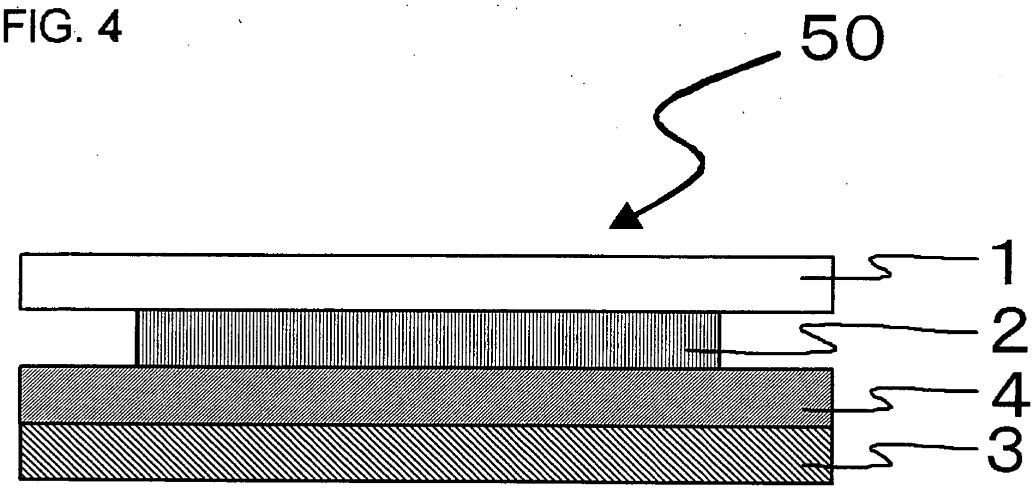


FIG. 5

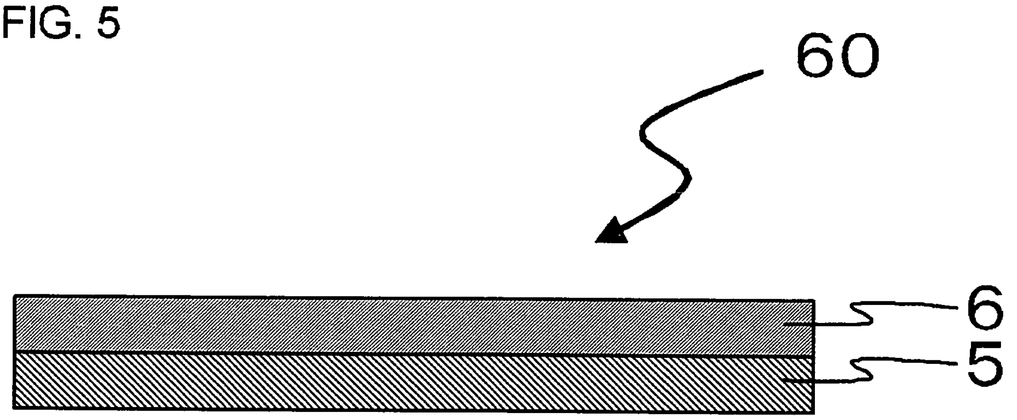


FIG. 6

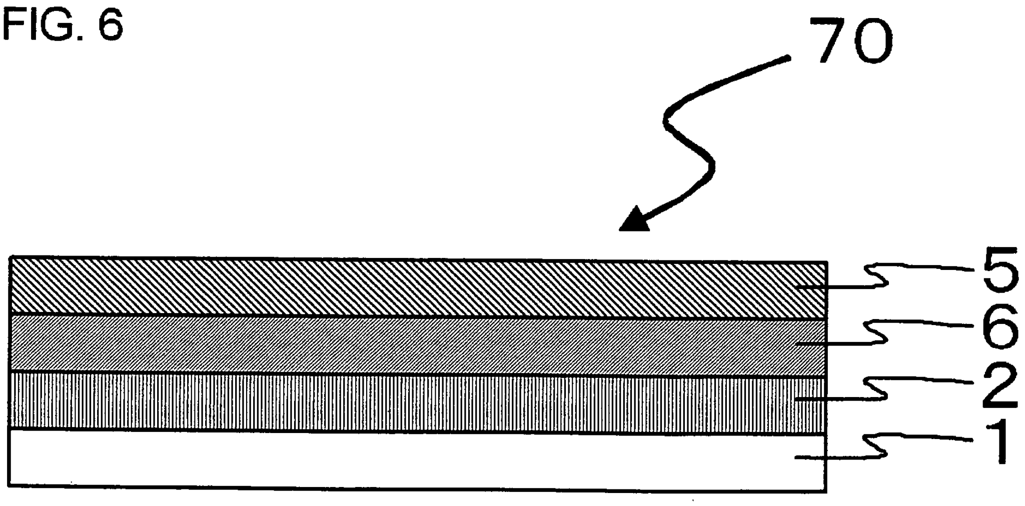

FIG. 7

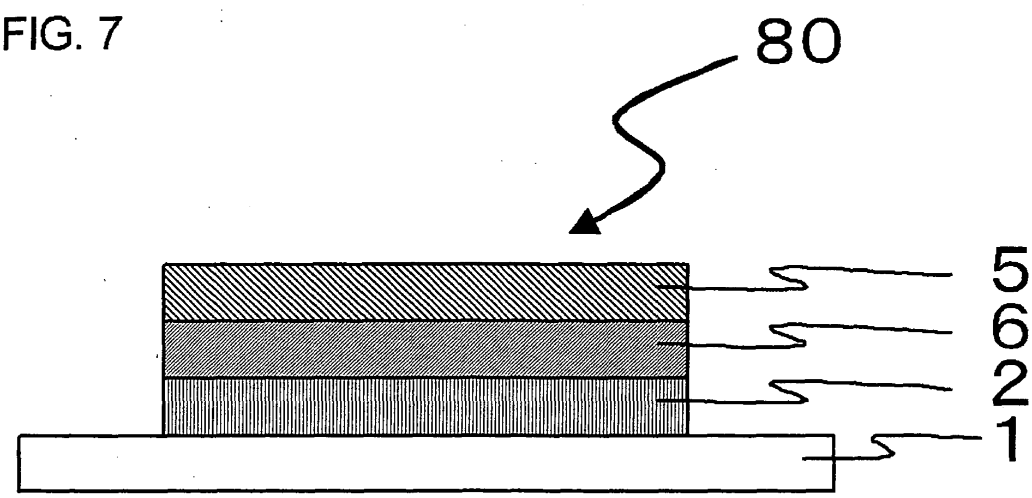


FIG. 8

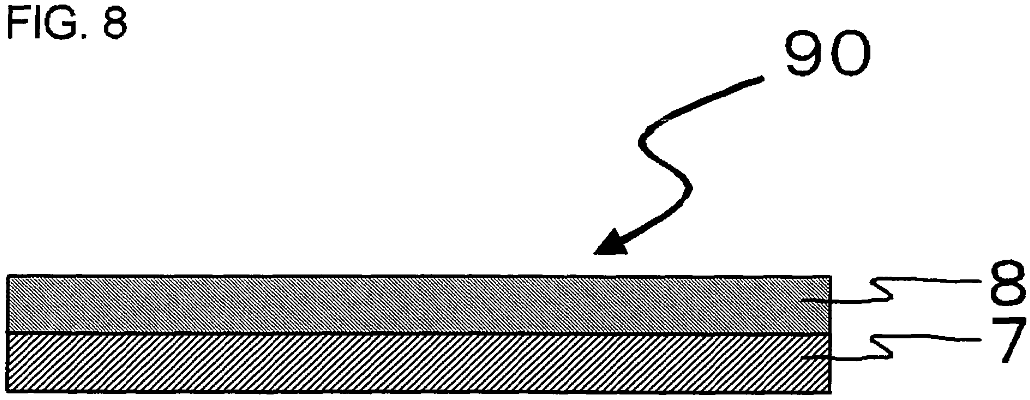

FIG. 9

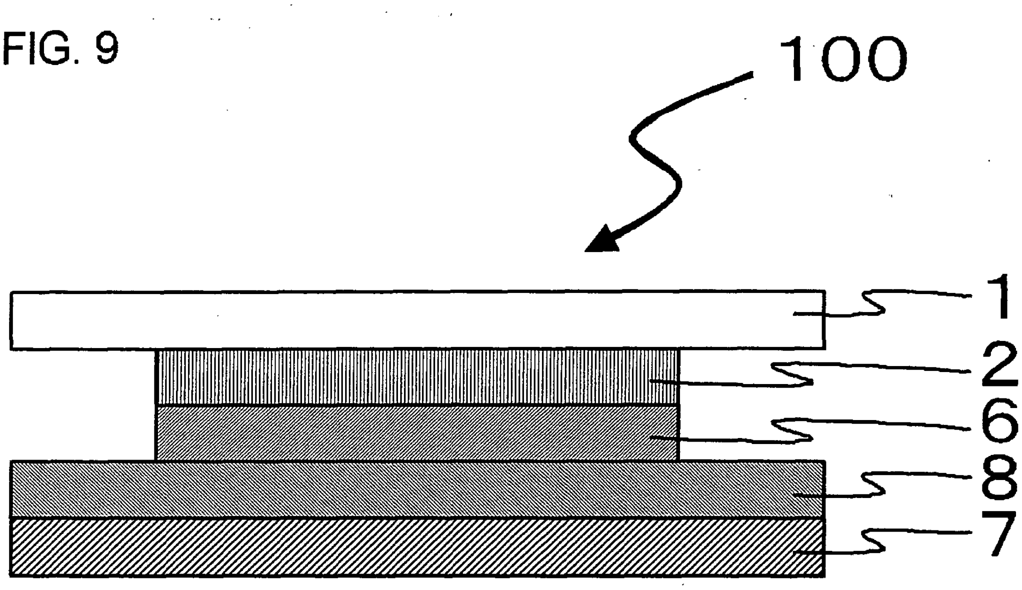


FIG. 10

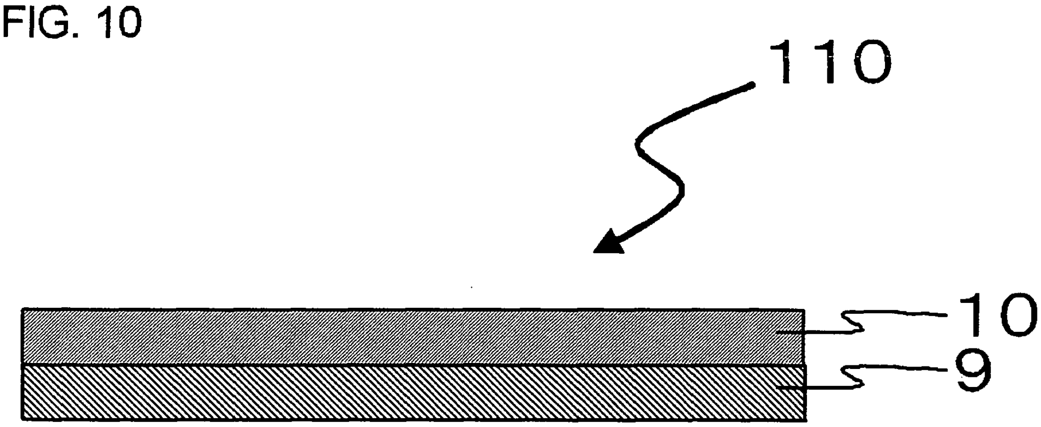

FIG.11

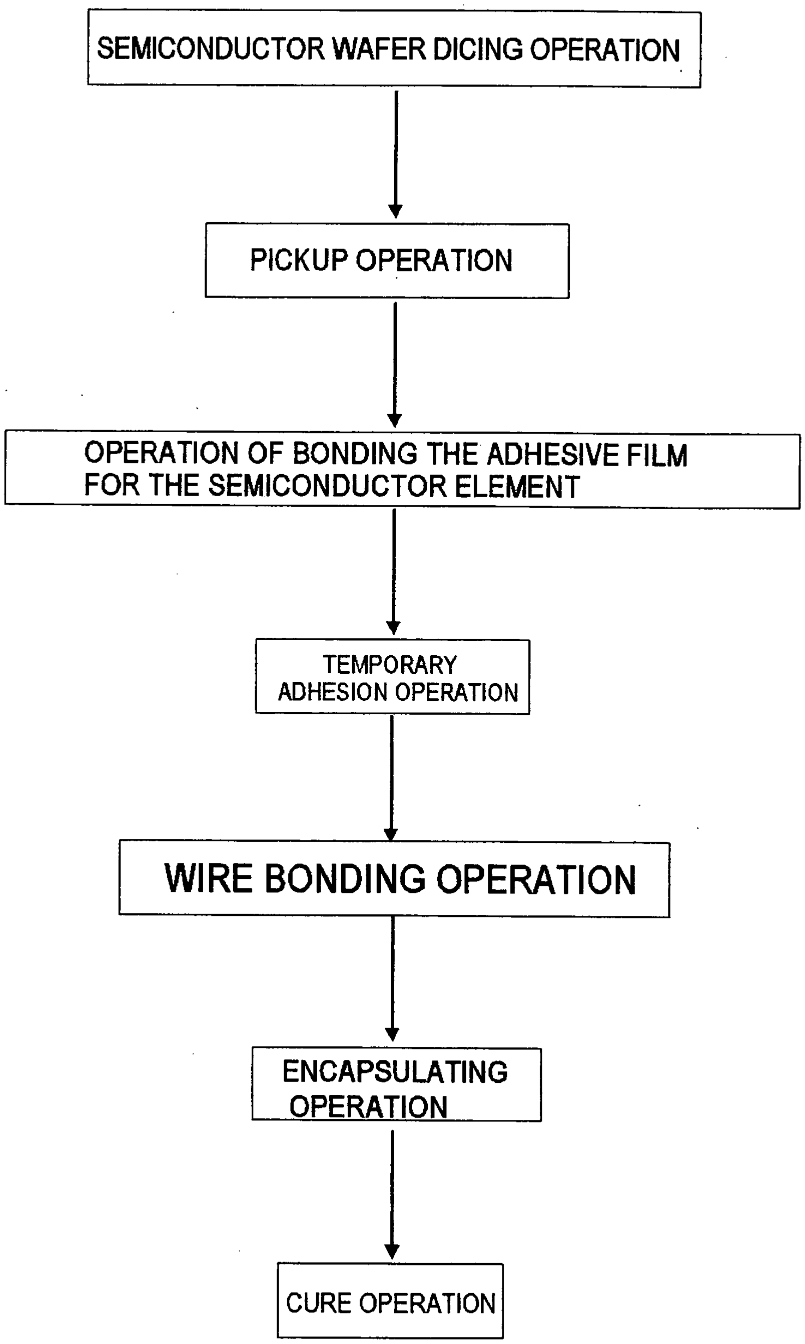
SEMICONDUCTOR WAFER DICING OPERATION
PICKUP OPERATION
OPERATION OF BONDING THE ADHESIVE FILM FOR THE SEMICONDUCTOR ELEMENT
TEMPORARY ADHESION OPERATION
WIRE BONDING OPERATION
ENCAPSULATING OPERATION
CURE OPERATION

FIG. 12

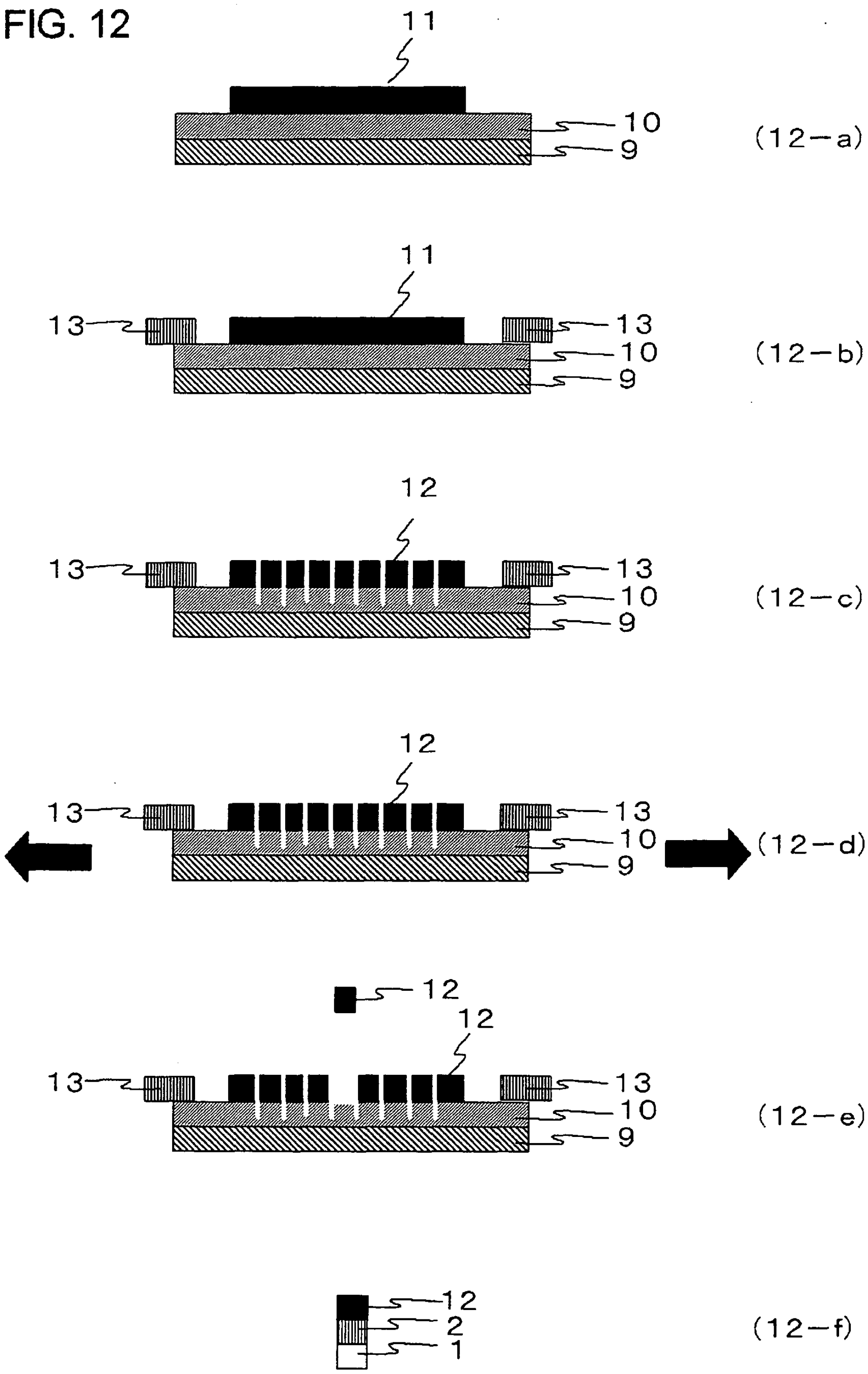
11
10
9
(12−a)
11
13
13
10
9
(12−b)
12
13
13
10
9
(12−c)
12
13
13
10
9
(12−d)
12
12
13
13
10
9
(12−e)
12
2
1
(12−f)

FIG. 13

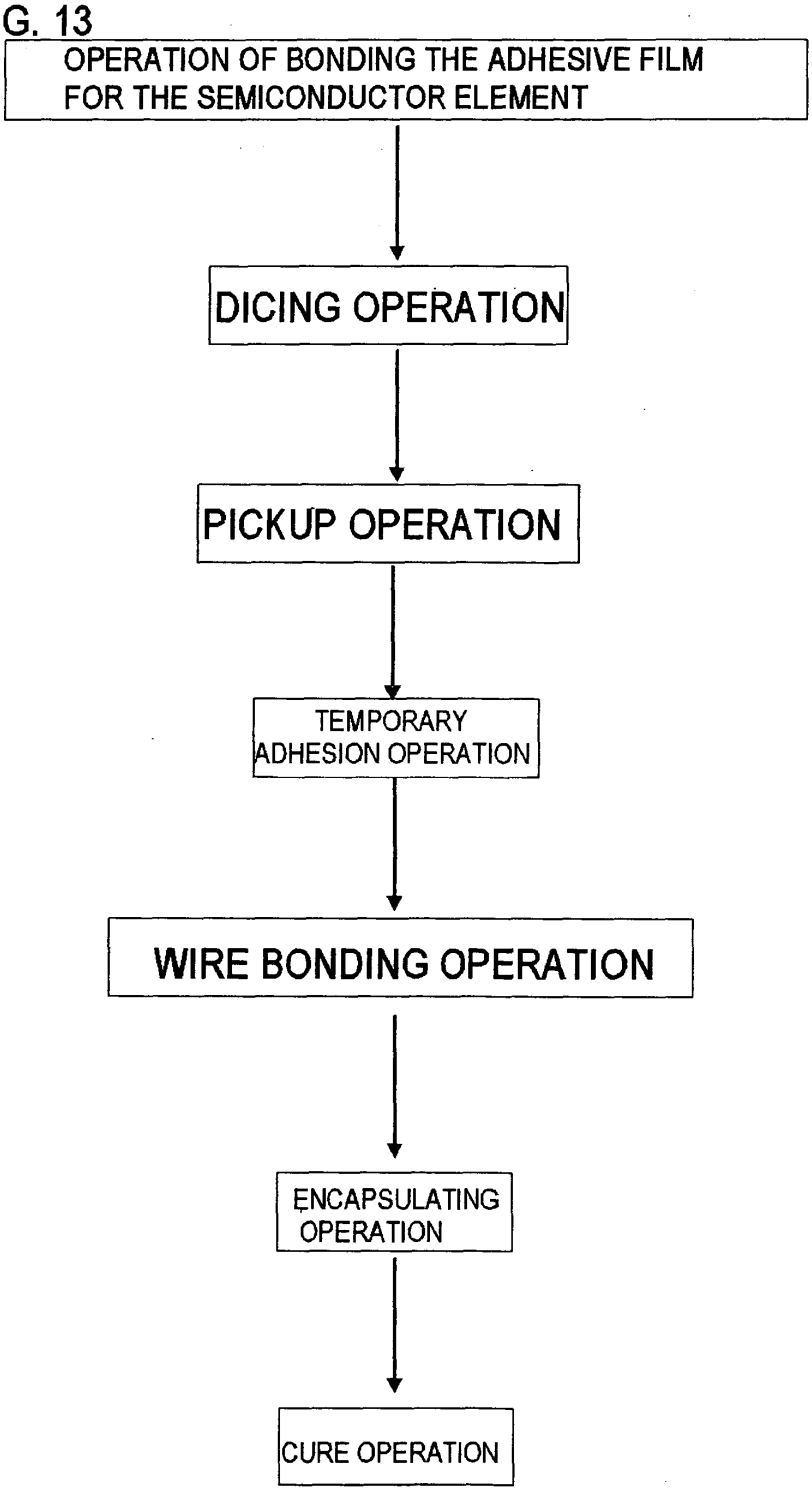
OPERATION OF BONDING THE ADHESIVE FILM FOR THE SEMICONDUCTOR ELEMENT
DICING OPERATION
PICKUP OPERATION
TEMPORARY ADHESION OPERATION
WIRE BONDING OPERATION
ENCAPSULATING OPERATION
CURE OPERATION

FIG. 14

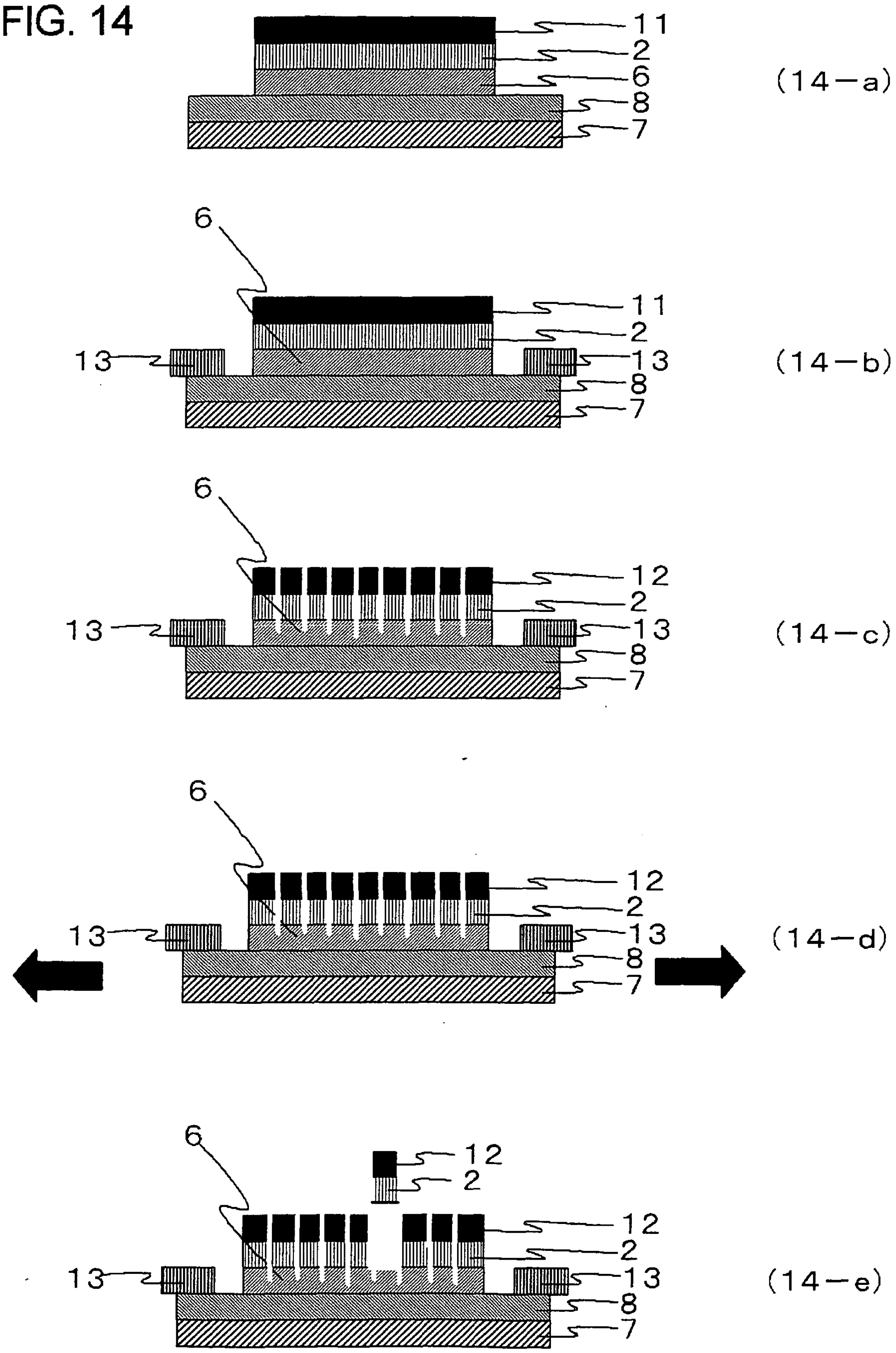
11
2
6
8
7
(14−a)
6
11
2
13
13
8
7
(14−b)
6
12
2
13
13
8
7
(14−c)
6
12
2
13
13
8
7
(14−d)
6
12
2
12
2
13
13
8
7
(14−e)

FIG. 15

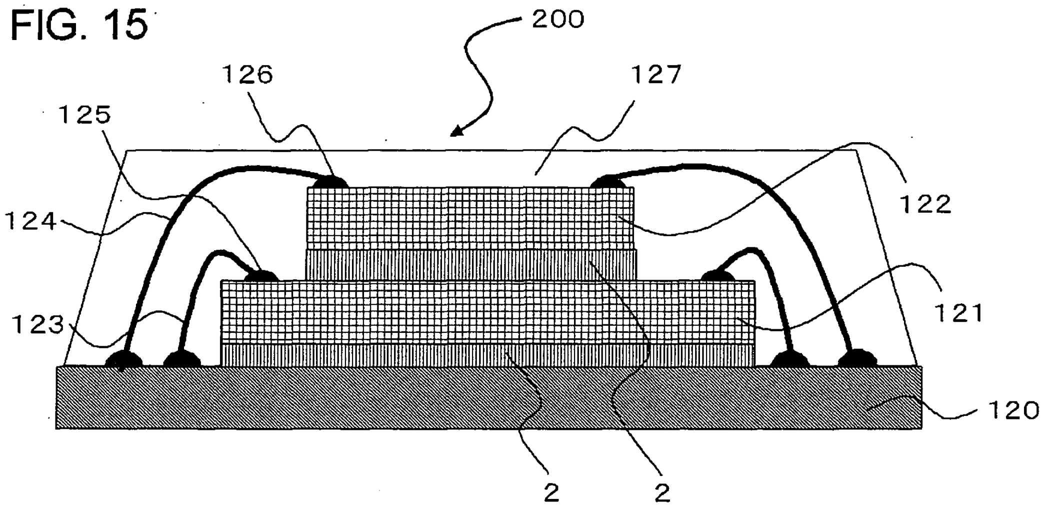

## INTERNATIONAL SEARCH REPORT

International application No.
PCT/JP2009/001059

A. CLASSIFICATION OF SUBJECT MATTER
*H01L21/52*(2006.01)i, *C09J7/02*(2006.01)i, *C09J11/02*(2006.01)i, *C09J133/20*(2006.01)i, *H01L21/301*(2006.01)i, *H01L25/065*(2006.01)i, *H01L25/07*(2006.01)i, *H01L25/18*(2006.01)i

According to International Patent Classification (IPC) or to both national classification and IPC

B. FIELDS SEARCHED

Minimum documentation searched (classification system followed by classification symbols)
H01L21/52, C09J7/02, C09J11/02, C09J133/20, H01L21/301, H01L25/065, H01L25/07, H01L25/18

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2007-088489 A (Sumitomo Bakelite Co., Ltd.), 05 April, 2007 (05.04.07), Full text (Family: none) | 1-24 |
| A | JP 2007-294681 A (Hitachi Chemical Co., Ltd.), 08 November, 2007 (08.11.07), Full text; Figs. 1 to 2 (Family: none) | 1-24 |
| A | JP 2007-302881 A (Hitachi Chemical Co., Ltd.), 22 November, 2007 (22.11.07), Full text; Figs. 1 to 2 (Family: none) | 1-24 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 April, 2009 (07.04.09) | 21 April, 2009 (21.04.09) |
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.
PCT/JP2009/001059

C (Continuation). DOCUMENTS CONSIDERED TO BE RELEVANT

| Category* | Citation of document, with indication, where appropriate, of the relevant passages | Relevant to claim No. |
|---|---|---|
| P,A | JP 2008-274259 A (Hitachi Chemical Co., Ltd.), 13 November, 2008 (13.11.08), Full text; Figs. 1 to 5 (Family: none) | 1-24 |
| P,A | WO 2008/105169 A1 (Sumitomo Bakelite Co., Ltd.), 04 September, 2008 (04.09.08), Full text; Figs. 1 to 4 (Family: none) | 1-24 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006073982 A
- JP 2001220571 A
- JP 2002138270 A
- JP H1112545 B